# EUROPÄISCHE PATENTSCHRIFT

(11) **EP 4 172 734 B1**
(45) Veröffentlichungstag und Bekanntmachung des Hinweises auf die Patenterteilung: **15.01.2025**
(21) Anmeldenummer: 21742735.0
(22) Anmeldetag: 26.06.2021
(51) Int. Cl.: G06F 3/01, G01R 33/00, H01H 25/06, G06F 3/0362, B60K 35/10, B60K 35/25, G01R 33/07, G05G 1/10, G05G 5/03, H01H 19/10, H01H 25/04, H01H 3/00, H01H 19/14, H01H 25/00

(54) **HAPTISCHE BEDIENEINRICHTUNG MIT EINER MAGNETORHEOLOGISCHEN BREMSEINRICHTUNG UND EINEM DREHBAREN BEDIENTEIL**
HAPTIC OPERATING DEVICE COMPRISING A MAGNETORHEOLOGICAL BRAKING DEVICE AND A ROTATABLE OPERATING PART
DISPOSITIF DE COMMANDE HAPTIQUE DOTÉ D'UN SYSTÈME DE FREINAGE MAGNÉTO-RHÉOLOGIQUE ET D'UN ÉLÉMENT DE COMMANDE ROTATIF

(30) Priorität: 26.06.2020 DE 102020116933
(43) Veröffentlichungstag der Anmeldung: 03.05.2023
(73) Patentinhaber: INVENTUS Engineering GmbH, 6771 St. Anton i.M. (AT)
(72) Erfinder: BATTLOGG, Stefan, 6771 St. Anton i.M. (AT)
(74) Vertreter: BSB Patentanwälte Schütte & Engelen Partnerschaft mbB
(86) Internationale Anmeldenummer: PCT/EP2021/067591
(87) Internationale Veröffentlichungsnummer: WO 2021/260214

(56) Entgegenhaltungen:
- EP-B1- 2 603 774
- EP-B1- 3 317 749
- WO-A1-2019/138015
- WO-A1-2020/008002
- DE-A1- 102017 104 206
- US-A1- 2018 073 590
- US-A1- 2019 146 546
- US-B2- 10 318 002

## Beschreibung

Die Erfindung betrifft eine haptische Bedieneinrichtung mit einem drehbaren Bedienteil, wenigstens einer Magnetfeldquelle und wenigstens einer magnetorheologischen Bremseinrichtung zum Bremsen einer Drehbewegung des Bedienteils.

Die haptische Bedieneinrichtung mit der magnetorheologischen Bremseinrichtung kann auf vielfältigen technischen Gebieten zum Bedienen von Geräten und anderen Einrichtungen eingesetzt werden. Die haptische Bedieneinrichtung kann zum Beispiel auch bei der Bedienung von technischen Einrichtungen in Fahrzeugen, (als Drehsteller; Dreh-/Drücksteller; für das Infotainment, die Klimaanlage, als Getriebewahlschalter, für die Navigation, zur Sitzverstellung, in der Lenkung oder im Lenkrad, zur Bedienung der Fahrwerksverstellung, Fahrmodiverstellung, Distanzeinstellung, Adaptive Cruise Control, Anhängersteuerung...), Kraftfahrzeugen, Luftfahrt- und Flugzeugen, Schiffen, Booten, in der Landtechnik (Traktoren, Mähdrescher, Erntemaschinen, sonstigen Feldmaschinen für die Landwirtschaft, Pistengeräte...), Baumaschinen und Maschinen für das Material Handling (Gabelstapler ...), Bearbeitungsmaschinen und -anlagen in der Industrie oder bei medizinischen oder industriellen Anlagen eingesetzt werden.

Die Erfindung kann auch bei der Bedienung oder als Eingabegerät von/für Waschmaschinen, Küchen-/Haushaltsgeräten und -einrichtungen, Radios, Fotoapparaten und Filmkameras, Hi-Fi- und Fernsehanlagen, Smart Devices, Smart-Home-Geräten, Laptops, PCs, Smartwatches, in einem Kronenrad von Armbanduhren oder als Eingabegerät für Computer oder als Computermaus oder als Drehrad in einer Computermaus oder Controllern, Spielkonsolen, Gamingequipment, Drehknopf in einer Tastatur oder anderen Geräten verwendet werden.

Die haptische Bedieneinrichtung weist eine magnetorheologische Bremseinrichtung auf, welche insbesondere mit einem magnetorheologischen Medium und vorzugsweise mit einem magnetorheologischen Fluid versehen ist. Magnetorheologische Fluide weisen beispielsweise in einem Öl verteilt feinste ferromagnetische Partikel wie beispielsweise Carbonyleisenpulver auf. In magnetorheologischen Flüssigkeiten werden kugelförmige Partikel mit einem herstellungsbedingten Durchmesser von 1 bis 10 um verwendet, wobei die Partikelgröße und Form nicht einheitlich ist. Wird ein solches magnetorheologisches Fluid mit einem Magnetfeld beaufschlagt, so verketten sich die Carbonyleisenpartikel des magnetorheologischen Fluids entlang der Magnetfeldlinien, sodass die rheologischen Eigenschaften des magnetorheologischen Fluides (MRF) abhängig von Form und Stärke des Magnetfeldes erheblich beeinflusst werden (übertragbare Schubspannungen). Dies gilt auch für magnetorheologische Medien, bei denen sich die Carbonyleisenpartikel des magnetorheologischen Mediums entlang der Magnetfeldlinien verketten, sodass abhängig von Form und Stärke des Magnetfeldes die übertragbaren Schubspannungen erheblich beeinflusst werden.

Mit der WO 2012/034697 A1 ist eine magnetorheologische Übertragungsvorrichtung bekannt geworden, die zwei koppelbare Komponenten aufweist, deren Kopplungsintensität beeinflussbar ist. Zur Beeinflussung der Kopplungsintensität ist ein Kanal mit einem magnetorheologischen Medium vorgesehen. Über ein Magnetfeld wird das magnetorheologische Medium in dem Kanal beeinflusst. In dem Kanal sind Drehkörper vorgesehen, an denen spitzwinklige und das magnetorheologische Medium enthaltende Bereiche vorgesehen sind. Der Kanal oder wenigstens ein Teil davon ist mit dem Magnetfeld einer Magnetfelderzeugungseinrichtung beaufschlagbar, um die Partikel wahlweise (magnetisch) zu verketten und mit dem Drehkörper zu verkeilen oder freizugeben. Diese magnetorheologische Übertragungsvorrichtung kann auch an einem Drehknopf zur Bedienung von technischen Geräten eingesetzt werden. Eine solche magnetorheologische Übertragungsvorrichtung funktioniert und erlaubt die Übertragung von recht hohen Kräften oder Drehmomenten bei gleichzeitig relativ kleiner Bauform bzw. Bauvolumen und Energiebedarf.

In der WO 2012/034697 A1 ist auch ein Drehknopf oder Bedienknopf offenbart, bei dem der eigentliche Knopf um eine Welle drehbar angebracht ist. Über das von einer elektrischen Spule erzeugte Magnetfeld kann das Bremsmoment gesteuert werden. Wird ein höheres erzeugbares Bremsmoment gewünscht, so können statt kugelförmiger Drehkörper auch zylindrische Walzen eingesetzt werden, sodass das Magnetfeld auf einer längeren Strecke bzw. größeren Fläche wirkt (es findet eine Magnetfeldkonzentration und Keilbildung über eine größere Fläche statt). Es hat sich insbesondere bei Dreh- oder Bedienknöpfen mit relativ kleinem Durchmesser gezeigt, dass eine Verlängerung der Wälzkörper nicht unbedingt zu einer Erhöhung des maximal erzeugbaren Bremsmomentes führt. Es hat sich herausgestellt, dass dies daran liegt, dass das Magnetfeld durch die zentrale Welle geschlossen wird bzw. hindurch gehen muss. Der kleine Durchmesser der Welle begrenzt das erzeugbare Bremsmoment, da das für die Bremsung erforderliche Magnetfeld im (Wellen)material schnell gesättigt ist. Das vom Magnetfeld durchflossene Material lässt keinen höheren Magnetfluss mehr zu, weshalb auch kein stärkeres Magnetfeld zu den Walzen gelangen kann. Der kleinste vom Magnetfeld durchflossene Querschnitt im Gesamtmagnetkreis definiert den maximal möglichen Magnetfluss und damit das maximale Bremsmoment in der Bremsvorrichtung. Der Einsatz von längeren Walzen als Drehkörpern kann sich dann sogar nachteilig auf das erzeugbare Bremsmoment auswirken, da sich das Magnetfeld über die längere Walzenfläche verteilt. Es liegt eine geringere Feldstärke (pro Übertragungsfläche) (geringe Magnetfeldkonzentration) an. Weil die erzielbare Bremswirkung nicht linear von dem Magnetfeld abhängt, sondern bei stärkeren Magnetfeldern überproportional steigt, sinkt die erzielbare Bremswirkung dementsprechend bei schwächeren Magnetfeldern überproportional.

Bei haptischen Bedieneinrichtungen für Computer oder für Maschinen oder Fahrzeuge aber auch generell spielen der Bauraumbedarf und der Preis (Herstellkosten) eine große Rolle. Bei einer Serienfertigung ist die Wahl der Materialien und Herstellverfahren von großer Bedeutung. Die Einsparung von Kosten ist ein wichtiges Thema. Gleichzeitig werden hohe Anforderungen an die Genauigkeit gestellt. Drehbare haptische Bedienelemente, die mit einer magnetorheologischen Bremseinrichtung gezielt abbremsbar sind sollen einerseits ein sehr niedriges Grundmoment aufweisen, damit eine leichte und unbelastende Bedienbarkeit gegeben ist und andererseits soll ein relativ hohes Bremsmoment aufbringbar sein, um ein deutlich fühlbares haptisches Feedback geben zu können.

Die WO 2019/138015 A1, US 10 318 002 B2, US 2018/073590 A1, EP 2 603 774 B1, DE 10 2017 104 206 A1 offenbaren haptische Bedieneinrichtungen, wobei auch der Einsatz von magnetorheologischen Bremseinrichtungen mit zwei relativ zueinander drehbaren Bremskomponenten gezeigt wird.

Es ist deshalb die Aufgabe der vorliegenden Erfindung, eine haptische Bedieneinrichtung mit einem drehbaren Bedienteil und mit einer magnetorheologischen Bremseinrichtung zur Verfügung zu stellen, welche einen einfachen und kostengünstigen Aufbau aufweist und welche insbesondere auch bei kleinen oder sogar bei sehr kleinen Durchmessern und einem insbesondere sehr kleinen Bauvolumen ein hohes Bremsmoment ermöglicht und eine verbesserte Funktion ermöglichen.

Diese Aufgabe wird durch eine haptische Bedieneinrichtung mit den Merkmalen des Anspruchs 1 gelöst. Bevorzugte Weiterbildungen der Erfindung sind Gegenstand der Unteransprüche. Weitere Vorteile und Merkmale der haptischen Bedieneinrichtung ergeben sich aus der allgemeinen Beschreibung und der Beschreibung der Ausführungsbeispiele.

Eine haptische Bedieneinrichtung umfasst wenigstens ein drehbares Bedienteil, wenigstens eine Magnetfeldquelle und wenigstens eine magnetorheologische Bremseinrichtung zum Bremsen einer Drehbewegung des Bedienteils. Die magnetorheologische Bremseinrichtung umfasst wenigstens zwei relativ zueinander drehbare oder wenigstens verschwenkbare Bremskomponenten, von denen eine mit dem drehbaren Bedienteil gekoppelt ist. Die zweite Bremskomponente umgibt als äußere Bremskomponente die erste Bremskomponente als innere Bremskomponente wenigstens abschnittsweise. Zwischen den beiden Bremskomponenten ist eine insbesondere (wenigstens abschnittsweise) geschlossene und mit einem magnetorheologischen Medium versehene magnetorheologische Bremskammer ausgebildet, welche wenigstens einen (umlaufenden) Spalt bzw. Bremsspalt aufweist. Insbesondere umfasst das magnetorheologische Medium ein flüssiges und/oder gasförmiges Trägermedium, in welchem magnetisch beeinflussbare Partikel aufgenommen sind. Die Partikel können auch ohne Trägermedium in der Bremskammer aufgenommen sein. Erfindungsgemäß erstreckt sich die innere Bremskomponente in einer axialen Richtung. Die innere Bremskomponente ist als Statoreinheit ausgebildet und die äußere Bremskomponente ist als Rotoreinheit ausgebildet. Die äußere Bremskomponente ist über wenigstens eine Lagereinheit an einem Tragkörper drehbar gelagert. Die wenigstens eine Lagereinheit stellt wenigstens ein Festlager zum Blockieren einer axialen Bewegbarkeit der äußeren Bremskomponente bereit. Mit der Lagereinheit erfolgt eine von der inneren Bremskomponente unabhängige Lagerung der äußeren Bremskomponente.

Besonders bevorzugt ist die Bremskammer über wenigstens eine Dichtung (nach außen) abgedichtet. Die (insbesondere mit dem magnetorheologischen Medium benetzte bzw. damit in Kontakt stehende) Dichtung umfasst eine mit der inneren Bremskomponente verbundene Dichtungsbasis und wenigstens eine an der äußeren Bremskomponente anliegende Dichtungslippe. Vorzugsweise umfasst die Dichtung eine nur mit der inneren Bremskomponente verbundene Dichtungsbasis und/oder wenigstens eine nur an der äußeren Bremskomponente anliegende Dichtungslippe.

Eine solche haptische Bedieneinrichtung mit einem drehbaren Bedienteil und mit wenigstens einer magnetorheologischen Bremseinrichtung hat viele Vorteile. Ein erheblicher Vorteil einer solchen haptischen Bedieneinrichtung besteht darin, dass die Dichtungslippe außen an der äußeren Bremskomponente anliegt und nicht innen an der inneren Bremskomponente. Das bietet erhebliche Vorteile auch in der Materialwahl der inneren Bremskomponente oder von Teilen der inneren Bremskomponente. Es ist nicht nötig, die innere Bremskomponente im Bereich der Dichtungsbasis aus Metall oder einem anderen harten Werkstoff zu fertigen oder eine separate Hülse aus einem solchen Werkstoff aufzubringen. Im Bereich der Aufnahme der Dichtungsbasis kann die innere Bremskomponente auch aus einem weichen Werkstoff und z. B. einem Kunststoff hergestellt werden. Das bietet vielfältige Möglichkeiten zur Verbesserung bei der Konstruktion und Fertigung.

Möglich und vorteilhaft ist aber auch ein anderer geeigneter Aufbau der Dichtung. Insbesondere wird bei der Ausführung der Dichtung auch das Trägermedium berücksichtigt, in welchem die magnetisch beeinflussbaren Partikel aufgenommen sind. Es kann vorgesehen sein, dass die Dichtung wenigstens eine mit der äußeren Bremskomponente verbundene Dichtungsbasis und/oder wenigstens eine an der inneren Bremskomponente anliegende Dichtungslippe aufweist. Möglich sind auch Kombinationen der zuvor beschriebenen Anordnungen von Dichtungsbasis und Dichtungslippe.

Die magnetorheologische Bremseinrichtung kann an einem Halter oder Tragkörper aufgenommen sein. Der Tragkörper kann an einer Konsole ausgebildet sein.

Die erste bzw. innere Bremskomponente erstreckt sich insbesondere in einer axialen Richtung und kann mit dem Tragkörper drehfest verbunden sein. Zwischen der ersten und der zweiten Bremskomponente ist ein umlaufender Spalt ausgebildet, der auch Bremsspalt oder Wirkspalt genannt werden kann. Der Spalt ist wenigstens zum Teil mit einem magnetorheologischen Medium gefüllt.

Dabei benetzt das magnetorheologische Medium insbesondere die erste und die zweite Bremskomponente wenigstens abschnittsweise. Unter einem Benetzen wird insbesondere jede Art von einer Berührung verstanden. Beispielsweise kann als Medium für die magnetisch beeinflussbaren Partikel auch Gas, Gasgemisch, Luft bzw. ein Vakuum vorgesehen sein. Dann werden die erste und die zweite Bremskomponente wenigstens abschnittsweise von Gas, Gasgemisch, Luft bzw. nur von den Partikeln berührt bzw. benetzt. Insbesondere steht dann auch die Dichtung in Kontakt mit Luft bzw. den Partikeln. Die Dichtung ist insbesondere dazu geeignet und ausgebildet, auch gegenüber in Luft und/oder in einem Vakuum befindlichen Partikeln abzudichten. Die erste Bremskomponente umfasst einen sich in der axialen Richtung erstreckenden Kern aus einem magnetisch leitfähigen Material und (wenigstens) eine elektrische Spule. Die elektrische Spule kann radial oder axial um den Kern gewickelt sein.

Vorzugsweise ist die elektrische Spule in axialer Richtung um den Kern gewickelt und spannt eine Spulenebene auf, sodass sich ein Magnetfeld der elektrischen Spule quer (zu der axialen Richtung) durch die erste Bremskomponente erstreckt.

Dabei ist es möglich und bevorzugt, dass ein maximaler (äußerer) Durchmesser der elektrischen Spule in einer radialen Richtung innerhalb der Spulenebene größer ist als ein minimaler (äußerer) Durchmesser des Kerns in einer radialen Richtung quer (und insbesondere etwa senkrecht oder senkrecht) zu der Spulenebene.

Die erste Bremskomponente definiert jedenfalls eine axiale Richtung. Die erste Bremskomponente kann aber auch wenigstens örtlich zur axialen Richtung gewinkelt ausgebildet sein. Unter der Formulierung, dass sich der Kern der ersten Bremskomponente in der axialen Richtung erstreckt, wird im Sinne der vorliegenden Erfindung verstanden, dass sich der Kern wenigstens auch im Wesentlichen in die axiale Richtung erstreckt. Der Kern kann einen Verlauf aufweisen, der vorzugsweise parallel zur axialen Richtung ausgerichtet ist, kann aber aber auch einen leichten Winkel zur axialen Richtung aufweisen. Beispielsweise kann der Kern auch unter einem Winkel von 2,5° oder 5° oder 10° oder 15° zur axialen Richtung ausgerichtet sein. Die Wicklung der elektrischen Spule muss ebenso nicht exakt in axialer Richtung um den Kern (oder radial darum herum) ausgerichtet sein. Auch die elektrische Spule kann unter einem Winkel von 5° oder 10° oder 15° oder dergleichen zur axialen Richtung um den Kern gewickelt sein. Es ist in allen Fällen aber bevorzugt, dass ein Winkel zwischen der Ausrichtung des Kerns und der axialen Richtung und ein Winkel der Wicklung der elektrischen Spule zur axialen Richtung kleiner 20° und insbesondere kleiner 10° beträgt.

Besonders bevorzugt ist der Spalt mit einem Magnetfeld der Magnetfeldquelle beaufschlagbar. Dabei durchtritt das Magnetfeld den Spalt. Das Magnetfeld wird (abschnittsweise) durch einen magnetisch leitfähigen äußeren Bremskörper der äußeren Bremskomponente geleitet. Die äußere Bremskomponente kann insbesondere weitgehend aus dem magnetisch leitfähigen äußeren Bremskörper bestehen oder gebildet werden. Besonders bevorzugt ist die äußere Bremskomponente in einem Kontaktbereich mit der Dichtungslippe widerstandsfähiger gegen Abrasion als die innere Bremskomponente in einem Kontaktabschnitt mit der Dichtungsbasis ausgebildet.

Besonders bevorzugt ist die Dichtungslippe elastisch ausgebildet und liegt mit einer (insbesondere geringen) Federkraft elastisch an der äußeren Bremskomponente und vorzugsweise an dem magnetisch leitfähigen äußeren Bremskörper dichtend an.

Bevorzugt weist die Dichtung eine mit der ersten Bremskomponente verbundene Dichtungsbasis und wenigstens eine und insbesondere genau eine an der zweiten Bremskomponente anliegende und umlaufende (elastische) Dichtungslippe auf und die zweite Bremskomponente ist in dem Kontaktbereich mit der (elastischen) Dichtungslippe härter als die innere Bremskomponente in dem Kontaktabschnitt mit der Dichtungsbasis ausgebildet.

Vorzugsweise ist die äußere Bremskomponente in dem Kontaktbereich widerstandsfähiger gegen durch die Dichtungslippe bewirkten Verschleiß als die innere Bremskomponente in einem Kontaktabschnitt mit der Dichtungsbasis. Eine Drehbewegung der Dichtungslippe relativ zu der inneren Bremskomponente und ein sich daraus möglicherweise ergebender Verschleiß wird vermieden. Deshalb kann - abgesehen von dem Kern - die innere Bremskomponente aus leichteren und weniger festen Materialien gebildet werden, z. B. aus einem Kunststoff oder aus einem weichen Metall (insbesondere auch aus einem weichmagnetischen Metall).

In allen Ausgestaltungen kann die Dichtungsbasis zum Beispiel mit der inneren Bremskomponente verklebt sein oder auch über elastische Kräfte an der inneren Bremskomponente halten. Die Dichtungsbasis kann z. B. auch über einen zentralen inneren Befestigungsring auf der inneren Bremskomponente haften. Dazu kann auf dem Innenumfang der Dichtungsbasis eine umlaufende Nut vorhanden sein, in die z. B. der Befestigungsring (z. B. ein O-Ring oder Quadring oder dergleichen) eingeführt wird. Der radial nach innen überstehende Befestigungsring haftet dann auf Außenoberfläche der inneren Bremskomponente, die gegebenenfalls auch über eine umlaufende Nut auf ihrer Außenoberfläche verfügt, um den Befestigungsring, die Dichtungsbasis und damit die Dichtung definiert zu positionieren. Die Dichtung kann aber auch über z. B. eine Schraube oder eine Mutter eingeklemmt werden, die aufgeschraubt wird.

Vorzugsweise ist die äußere Bremskomponente drehbar. Dabei ist die äußere Bremskomponente vorzugsweise nicht nur um einen bestimmten (und limitierten) Winkelbetrag verschwenkbar angeordnet, sondern kann ohne Beeinflussung durch die magnetorheologische Bremseinrichtung frei gedreht werden. Vorzugsweise ist das Bedienteil mit der äußeren Bremskomponente gekoppelt und insbesondere im Wesentlichen oder auch vollständig drehfest verbunden.

Möglich ist es auch, dass die innere Bremskomponente drehbar ist und dass das Bedienteil mit der inneren Bremskomponente gekoppelt ist.

Vorzugsweise weist die innere Bremskomponente einen Schaft aus einem Kunststoff auf. An und/oder auf dem Schaft ist vorzugsweise die Dichtungsbasis aufgebracht oder fixiert.

Besonders bevorzugt weist die Dichtung einen U-, V-, C- oder W-förmigen oder scheibenförmigen Querschnitt auf. Besonders bevorzugt ist der U-, V-, C- oder W-förmige Querschnitt zu dem Bremsspalt hin geöffnet. Dadurch wird bei einem zum Beispiel durch die Temperatur bedingten Druckanstieg im Inneren die Dichtwirkung noch verstärkt.

Die innere Bremskomponente erstreckt sich erfindungsgemäß in einer axialen Richtung bzw. definiert eine axiale Richtung. Die innere Bremskomponente ist als Statoreinheit ausgebildet und die äußere Bremskomponente ist als Rotoreinheit ausgebildet. Vorzugsweise ist die Rotoreinheit gegenüber der Statoreinheit drehbar.

Besonders bevorzugt weist die innere Bremskomponente einen Statorkörper mit einem Kern aus einem magnetisch leitfähigen Material und eine um den Kern gewickelte elektrische Spule als Magnetfeldquelle auf.

Vorzugsweise ist ein maximaler äußerer Durchmesser der elektrischen Spule in einer radialen Richtung innerhalb der durch die elektrische Spule aufgespannten Ebene (Spulenebene) größer als ein minimaler äußerer Durchmesser des Kerns in einer radialen Richtung quer zu der Spulenebene.

Ein besonderer Vorteil ergibt sich, wenn die elektrische Spule in axialer Richtung um wenigstens einen wesentlichen Teil des Kerns oder insgesamt um den Kern gewickelt ist. Wenn ein maximaler äußerer Durchmesser der elektrischen Spule in einer radialen Richtung innerhalb der Spulenebene größer ist als ein minimaler äußerer Durchmesser des Kerns in einer radialen Richtung quer und insbesondere wenigstens etwa senkrecht zu der Spulenebene, kann ein größerer Kerndurchmesser realisiert werden. Ein größerer Kernquerschnitt ermöglicht die Erzeugung eines stärkeren Magnetfeldes (höhere Feldstärken im Bremsspalt bzw. Wirkspalt). Dadurch können höhere Bremskräfte bei gleichem Bauraum oder aber gleich hohe Bremskräfte bei geringerem Bauraum erzeugt werden, das erzielbare Drehmoment pro Bauvolumen nimmt damit zu. Bei Bedarf ist es auch möglich, in einem sehr kleinen Bauraum noch beachtliche Bremskräfte zu erzeugen.

Das ergibt sich dadurch, dass das Magnetfeld der elektrischen Spule quer zur axialen Richtung der ersten Bremskomponente verläuft (also radial bezogen auf die Längsachse), und, dass der Durchmesser der elektrischen Spule vergrößert wird.

Es ist ein erheblicher Unterschied zu dem mit der WO 2012/034697 A1 bekannt gewordenen Stand der Technik, wo die elektrische Spule an der äußeren Komponente vorgesehen ist und wobei sich die Wicklungen der elektrischen Spule konzentrisch um die axiale Richtung herum erstrecken. Dadurch wird in diesem Stand der Technik ein Magnetfeld erzeugt, welches sich in axialer Richtung durch das Innere der beiden Komponenten erstreckt. Die innere Komponente, meist eine konstruktiv bedingte dünne Welle, beschränkt somit bei diesem Stand der Technik den Magnetflussquerschnitt und damit den maximal zu erzielenden Gesamtmagnetfluss. Im Unterschied dazu verläuft das Magnetfeld bzw. verlaufen die Magnetfeldlinien in dieser Weiterbildung quer dazu und somit quer durch die erste bzw. innere Bremskomponente. Eine Verlängerung der ersten Bremskomponente erhöht hier bei gleichem Durchmesser den möglichen Magnetfluss und damit das Bremsmoment. Der meist konstruktiv (bauraumbedingt) nicht größer mögliche Kerndurchmesser beschränkt somit nicht mehr den Magnetfluss. Die Wicklung(en) der elektrischen Spule liegen bei der vorliegenden Erfindung vorzugsweise (wenigstens im Wesentlichen) in einer Ebene oder dicht benachbart zu der Ebene, welche die zentrale Achse der axialen Richtung einschließt. Bei der WO 2012/034697 A1 liegt die zentrale Achse hingen senkrecht zu der Ebene der Wicklungen der elektrischen Spule.

Eine solche Ausgestaltung ist auch sehr vorteilhaft gegenüber dem Stand der Technik aus der WO 2019/138015 A1, die eine magnetorheologische Bremseinrichtung mit einer um eine Längsachse gewickelten elektrischen Spule zeigt. Im Unterschied dazu kann das magnetische Feld im Kern vergrößert und damit auch die Bremskraft erhöht und/oder der Bauraum verkleinert werden. Bei diesem Stand der Technik sind auf dem vollständigen Umfang Wälzkörper angeordnet und können umlaufen. Es ist überraschend, dass mit einer Konstruktion, bei der ein vollständiges Umlaufen der Wälzkörper nicht mehr möglich ist, da die elektrische Spule nach außen übersteht, eine Verstärkung der Bremskraft erzielbar ist.

Dies wird dadurch erreicht, dass der vorhandene Bauraum günstig und insbesondere bestmöglich genutzt wird. Ziel ist es, eine möglichst hohe magnetische Feldstärke (viel Amper/Meter) im Wirkspalt zwischen den sich zueinander bewegenden Wirkflächen (drehenden zu stehenden Komponenten) zu erzeugen. Damit dies möglich ist, werden bestimmte magnetische Querschnitte im den vom Magnetfeld durchflossenen Komponenten (Magnetkreis) benötigt, welche wiederum von einer elektrischen Spule mit dazu passendem Wickelfenster und elektrischer Auslegung (Drahtstärke/Drahtdurchmesser, Anzahl Wicklungen/Windungen) gespeist werden müssen. Dies alles innerhalb eines meist vorgegebenen (und oft knapp bemessenen) Bauraums.

Versuche beim Stand der Technik haben ergeben, dass eine z. B. vollständig mit Walzen bestückte Bremseinheit weniger Bremsmoment als eine teilweise bestückte ergibt, weil bei einer vollständig bestückten Bremseinheit das von der Elektrospule erzeugte und über den geometrisch restriktierten Kern erzeugte Magnetfeld auf mehrere Übertragungselemente verteilt wird, wodurch pro Übertragungseinheit weniger Feldstärke ankommt. Weniger Feldstärke führt überproportional zu weniger Bremsmoment. Bei dieser Weiterbildung der Konstruktion wurde die MRF Bremse nicht mit magnetisch nicht-leitenden Walzen (quasi sind dies Platzhalter) ausgeführt, sondern der Platz für diese nicht Drehmoment erzeugenden Bauteile wurde für die Vergrößerung der Elektrospule und des Kernes genutzt, sodass mehr Magnetfeld erzeugt wird. Dadurch ergibt sich eine Erhöhung des Bremsmomentes im gleichen Bauraum, weil dadurch die Feldstärke im Wirkspalt erhöht wird. Der Bauraum wurde bestmöglich genutzt.

Bei der magnetorheologischen Bremseinrichtung sind die Übertragungskomponenten wenigstens zum Teil von einem magnetorheologischen Medium umgeben. Insgesamt wird vorzugsweise ein magnetorheologisches Fluid als magnetorheologisches Medium eingesetzt.

Vorzugsweise sind über dem Umfang des Spaltes mehrere insbesondere drehbare Übertragungskomponenten verteilt angeordnet. Die Übertragungskomponenten können in dem Spalt drehbar sein und drehen sich dann vorzugsweise wenigstens zum Teil während einer Drehung der ersten und zweiten Bremskomponente relativ zueinander. Ein zentraler Bestandteil der drehbaren Übertragungskomponente oder die drehbare Übertragungskomponente insgesamt ist insbesondere formstabil und ändert während einer Drehung die äußere Form (wenigstens im Wesentlichen) nicht. Vorzugsweise dreht sich die drehbare Übertragungskomponente wenigstens etwas während einer Drehung der zweiten Bremskomponente relativ zu der ersten Bremskomponente.

In einer bevorzugten Weiterbildung ist wenigstens eine Übertragungskomponente als Wälzkörper ausgebildet. Unter dem Begriff "Wälzkörper" ist im Sinne der vorliegenden Erfindung ein Drehkörper zu verstehen, der geeignet ist, in dem Spalt auf der ersten bzw. zweiten Bremskomponente abzurollen.

Vorzugsweise weist wenigstens ein Wälzkörper einen zylindrischen oder kugelförmigen oder runden oder abgerundeten (im Wesentlichen formstabilen) Querschnitt auf. Insbesondere kann ein Wälzkörper einen (lang gestreckten) zylindrischen Abschnitt aufweisen. An den Enden kann der Wälzkörper abgerundet sein oder spitz zulaufend oder eckig gestaltet sein. Auch andere Abschnitte und insbesondere Endabschnitte sind möglich. Besonders bevorzugt werden zylindrische Walzen als Wälzkörper eingesetzt. Ein zylindrischer Wälzkörper hat den erheblichen Vorteil, dass der Wälzkörper über der Länge des zylindrischen Abschnitts wirksam sein kann. Dadurch wird die Effektivität erhöht.

Ein erheblicher Vorteil der vorliegenden Erfindung besteht darin, dass durch eine Verlängerung eines beispielsweise zylindrischen Wälzkörpers ein stärkeres Bremsmoment erzeugbar ist. Gleichzeitig mit der Verlängerung des Wälzkörpers kann (in sinnvoller Weise) auch die elektrische Spule verlängert werden, die sich in Längsrichtung der ersten Bremskomponente erstreckt. Mit einer elektrischen Spule, die in axialer Richtung länger ausgebildet ist, wird eine größere Durchtrittsfläche (vom Magnetfeld durchflossene Querschnittsfläche) für das Magnetfeld zur Verfügung gestellt. Deshalb bewirkt bei dieser Weiterbildung eine Verlängerung der ersten Bremskomponente in axialer Richtung auch eine Vergrößerung des Querschnitts des Kerns. Dadurch kann ein stärkeres Bremsmoment durch eine Verlängerung der ersten Bremskomponente in axialer Richtung erreicht werden.

In bevorzugten Ausgestaltungen besteht wenigstens ein Teil der Übertragungskomponenten aus einem magnetisch leitfähigen Material. Es ist möglich, dass ein Teil der Übertragungskomponenten aus einem magnetisch nicht leitfähigen Material besteht. Vorzugsweise besteht die Mehrzahl der Übertragungskomponenten aus einem magnetisch leitfähigen Material. In allen Fällen konzentriert sich das Magnetfeld im Bereich der magnetisch leitfähigen Übertragungskomponenten. Das führt zu der Konzentration des Magnetfeldes und zu einer örtlichen Verstärkung (Magnetfeldlinienkonzentration). Da der Zusammenhang zwischen erzeugbarem Bremsmoment und Stärke des Magnetfeldes nicht linear ist und da das erzeugbare Bremsmoment mit stärker werdendem Magnetfeld noch überproportional stärker wird, kann dadurch eine erhebliche Verstärkung des erzeugbaren Bremsmomentes (bei gleichem Bauraum/Abmessungen) erzielt werden.

Die Eisenpartikel werden in Richtung des Magnetfeldgradienten gezogen (die Kraft auf magnetisierbare Partikel wirkt immer in Richtung des stärkeren Magnetfelds). Dadurch wird die Konzentration der Carbonyleisenpartikel in den Bereichen höherer Magnetfeldlinienkonzentration auch erhöht. Zum Beispiel erhöht sich die magnetische Feldstärke im Spalt dadurch von < 350 A/m auf Werte größer 350 A/m und auf Werte von bis zu 1.000 A/m (1 kA/m) oder darüber. Die hohe (konzentrierte) Feldstärke zieht mehr Carbonyleisenpartikel aus der magnetorheologischen Flüssigkeit an, es kommt zu einer Carbonyleisen-Anhäufung (Haufenbildung). Dies wiederum erlaubt die Generierung höherer Schubspannungen und damit Bremsmomente.

In allen Ausgestaltungen ist es für eine Erhöhung des erzeugbaren Bremsmomentes nicht nötig, den Durchmesser der ersten Bremskomponente zu erhöhen. Dies ist deshalb sehr wichtig, weil viele Einsatzmöglichkeiten einen größeren Außendurchmesser einer Bremseinrichtung nicht zulassen bzw. ein größerer Außendurchmesser ein gravierender Wettbewerbsnachteil wäre (wie z. B. ein übergroßes seitliches Einstellrad bei einer Armbanduhr). Für eine Verstärkung/Erhöhung des Bremsmomentes kann die erste Bremskomponente axial länger ausgebildet werden, was bauraumtechnisch je nachdem kein bzw. ein kleinerer Nachteil ist.

Die äußere Bremskomponente weist insbesondere einen magnetisch leitfähigen äußeren Bremskörper auf. Vorzugsweise weist die äußere Bremskomponente und insbesondere der äußere Bremskörper der äußeren Bremskomponente (in axialer Richtung) wenigstens abschnittsweise eine zylindrische Innenoberfläche auf.

An wenigstens einem Winkelsegment des Außenumfangs des Kerns ist vorzugsweise wenigstens eine Übertragungskomponente zwischen dem Kern und der zylindrischen Innenoberfläche des magnetisch leitfähigen äußeren Bremskörpers angeordnet. Insbesondere weist an dem Winkelsegment der Kern und/oder die Statoreinheit seitlich neben dem Kern ausgebildete Formelemente auf, welche wenigstens eine an die Form der Übertragungskomponenten angepasste Aufnahme ausbilden. Bei zylindrisch ausgebildeten walzenförmigen Übertragungskomponenten ist der Kern im Bereich der Aufnahme vorzugsweise entsprechend konkav ausgebildet. Vorzugsweise ist nur ein geringer Spalt zwischen der Aufnahme und der Übertragungskomponente ausgebildet. Dadurch wird die Übertragungskomponente von der Aufnahme eingefasst und es findet eine besonders effektive Übertragung des Magnetfeldes auf die Übertragungskomponente statt.

In anderen Ausgestaltungen oder abgesehen von den Bereichen der Aufnahmen ist die Außenoberfläche des Kerns (wenigstens oder nur) über dem Winkelsegment vorzugsweise zylindrisch ausgebildet.

Insbesondere ist die elektrische Spule außerhalb des Winkelsegments an dem Kern aufgenommen. Besonders bevorzugt ragt die elektrische Spule radial weiter nach außen als die Außenoberfläche des Kerns in dem Winkelsegment.

In allen Ausgestaltungen sind vorzugsweise wenigstens zwei Winkelsegmente ausgebildet, an denen Übertragungskomponenten angeordnet sind, wobei insbesondere wenigstens ein Winkelsegment und vorzugsweise jedes Winkelsegment kleiner 150° ist.

In vorteilhaften Ausgestaltungen sind Übertragungskomponenten nur in dem Winkelsegment oder in den (insbesondere zwei) Winkelsegmenten angeordnet.

In vorteilhaften Weiterbildungen ist zwischen den radial äußeren Enden der Übertragungskomponenten und der zylindrischen Innenoberfläche des magnetisch leitfähigen äußeren Bremskörpers ein kleineres radiales Spaltmaß ausgebildet, als ein radialer Abstand zwischen der Spule und der zylindrischen Innenoberfläche des (magnetisch leitfähigen) äußeren Bremskörpers. An den radial äußeren Enden der Übertragungskomponenten liegt bevorzugt ein Spalt mit einer geringen Spalthöhe vor (Wirkspalt). Dadurch kann in Kombination mit hohen Feldstärken ein vorteilhafter Keileffekt eingestellt werden.

Es ist möglich, dass der Kern mit einer Mehrzahl an Übertragungskomponenten fest verbunden ist. Dann ist es möglich, dass keine Übertragungskomponente drehbar ist. Möglich ist es aber auch, dass einzelne Übertragungskomponenten fest mit dem Kern verbunden sind und dass andere Übertragungskomponenten als separate Teile vorgesehen sind, die sich gegebenenfalls auch gegenüber dem Kern bewegen oder drehen können. Diese können seitlich drehbar geführt sein.

Die mit dem Kern fest verbundenen Übertragungskomponenten können einstückig mit dem Kern ausgebildet oder damit fest verbunden und z. B. verschraubt oder vernietet oder verschweißt oder auf eine beliebige andere Art drehfest verbunden sein.

Vorzugsweise bilden wenigstens einige (fest mit dem Kern verbundene) Übertragungskomponenten nach außen abstehende Arme des Kerns.

Es hat sich überraschend gezeigt, dass eine besonders starke Verkettung der magnetorheologischen Partikel in dem magnetorheologischen Medium auch ohne (drehende) Wälzkörper erzeugt werden kann. Mit einem starken Magnetfeld und hohen Feldstärken im Wirkspalt kann eine effektive Verkettung und Anhäufung von Carbonyleisenpartikel erreicht werden. Die Übertragungskomponenten dienen in allen Fällen als Magnetfeldkonzentratoren. Übertragungskomponenten können auch als Magnetfeldkonzentratoren bezeichnet werden. Durch die hohe Feldkonzentration im Bereich der Übertragungskomponenten wird eine besonders hohe Feldstärke und damit auch eine besonders starke Verkettung und Anhäufung von Partikeln realisiert. Der Keileffekt verstärkt den Effekt, da der Spalt nicht umlaufend eine konstante Höhe aufweist, sondern sich verjüngt. Im Bereich der Übertragungskomponenten wird die radiale Spalthöhe reduziert, während sich daneben Bereiche verketten und eine Art Klumpen/Haufen bilden können.

In allen Ausgestaltungen ist es bevorzugt, dass die erste Bremskomponente axial verschieblich oder verschiebbar an der zweiten Bremskomponente und/oder dem Tragkörper aufgenommen ist.

Vorzugsweise ist wenigstens eine Sensoreinrichtung umfasst, wobei die Sensoreinrichtung wenigstens eine (insbesondere an der äußeren mittelbar oder unmittelbar Bremskomponente befestigte und besonders bevorzugt damit drehfest gekoppelte) Magnetringeinheit und wenigstens einen drehfest an der ersten Bremskomponente angebundenen sowie radial und/oder axial benachbart zu der Magnetringeinheit angeordneten Magnetfeldsensor zur Erfassung eines Magnetfeldes der Magnetringeinheit umfasst. Insbesondere wird wenigstens ein Hallsensor eingesetzt. Vorteilhaft ist ein zwei- oder dreidimensionaler Hallsensor. Die Magnetringeinheit weist vorzugsweise an einem radialen Ende einen Südpol und an dem gegenüberliegenden radialen Ende einen Nordpol auf. Durch eine Erfassung der Orientierung der Magnetfeldlinien innerhalb (radial innerhalb) der Magnetringeinheit kann so eine Bestimmung der Winkelposition der beiden Bremskomponenten relativ zueinander erfolgen.

Insbesondere ist die Magnetringeinheit (mittelbar) an dem äußeren Bremskörper befestigt.

In allen Weiterbildungen ist es bevorzugt, dass wenigstens eine Abschirmeinrichtung zur wenigstens teilweisen Abschirmung der Sensoreinrichtung vor einem Magnetfeld der elektrischen Spule und/oder anderer Komponenten und/oder einem sonstigen externen Magnetfeld umfasst ist.

Insbesondere umfasst die Abschirmeinrichtung wenigstens einen die Magnetringeinheit wenigstens abschnittsweise umgebenden Abschirmkörper. Vorzugsweise weist die Abschirmeinrichtung wenigstens eine zwischen dem Abschirmkörper und der Magnetringeinheit angeordnete Trenneinheit und/oder wenigstens eine zwischen dem Abschirmkörper und der äußeren Bremskomponente (dem äußeren Bremskörper oder einem damit verbundenen magnetisch nicht-leitenden Körper) angeordnete magnetische Entkopplungseinrichtung auf.

Die Trenneinheit und die Entkopplungseinrichtung weisen insbesondere eine um ein Vielfaches geringere magnetische Leitfähigkeit als der Abschirmkörper auf. Dadurch wird eine besonders vorteilhafte Abschirmung von eventuell störenden Magnetfeldern bewirkt. Dabei besteht der eventuell mehrteilig ausgebildete Abschirmkörper aus einem solchen magnetisch leitfähigen Material und weist eine solche Wandstärke auf, dass in normal üblichen Betrieb keine magnetische Sättigung in wenigstens einer Wandung oder in den Wandungen des Abschirmkörpers auftritt. Dadurch wird eine effektive Abschirmung gewährleistet und es kann eine hohe Qualität des Messsignals erreicht werden.

Die Abschirmeinrichtung kann mehrteilig ausgebildet sein und mehrere miteinander verbundene Komponenten umfassen. Insbesondere umfasst die Abschirmeinrichtung wenigstens eine Ringhülse und wenigstens eine axiale Ringscheibe oder z. B. zwei axiale Ringscheiben, wobei dann an jedem Ende eine axiale Ringscheibe angeordnet werden kann.

Insbesondere wird die Sensoreinrichtung radial zentrisch und etwa axial mittig an der (ein Zylinderabschnittsvolumen aufspannenden) Abschirmeinrichtung angeordnet. Eine axial leicht außermittige Position kann vorteilhaft sein, wenn über eine Stärke des gemessenen Magnetfeldes eine axiale Position abgeleitet wird.

In besonders vorteilhaften Ausgestaltungen sind die Abschirmeinrichtung und die Magnetringeinheit voneinander in radialer und axialer Richtung beabstandet angeordnet. Beispielsweise kann eine Trenneinheit aus einem magnetisch nicht oder nur schwach leitfähigen Material zwischen dem Abschirmkörper und der Magnetringeinheit vorgesehen sein. Die Trenneinheit kann z. B. aus einem Kunststoff bestehen. Beispielsweise kann die Trenneinheit aus einem Spritzgussteil bestehen. Vorzugsweise sorgt die Trenneinheit für einen definierten Abstand und eine definierte Positionierung.

Es ist bevorzugt, dass zwischen den beiden Bremskomponenten eine geschlossene (und nach außen abgedichtete) Kammer ausgebildet ist. Es ist möglich und bevorzugt, dass die zweite Bremskomponente (etwa) an einem ersten Ende der geschlossenen Kammer an der ersten Bremskomponente (an einer ersten Lagerstelle) drehbar aufgenommen oder auch gelagert ist. Die geschlossene Kammer ist besonders bevorzugt im Wesentlichen und insbesondere vollständig mit dem magnetorheologischen Medium gefüllt.

Vorzugsweise ist die zweite bzw. äußere Bremskomponente axial verschieblich an der ersten bzw. inneren Bremskomponente aufgenommen und z. B. gelagert, sodass sich ein Volumen der geschlossenen Bremskammer durch eine relative axiale Verschiebung der beiden Bremskomponenten zueinander verändert, um einen Ausgleich für temperaturbedingte Volumenänderungen zur Verfügung zu stellen.

Es ist möglich, dass an einem zweiten Ende der Bremskammer die zweite Bremskomponente an der ersten Bremskomponente verschlieblich aufgenommen ist (und kann dort separat gelagert sein), wobei ein Durchmesser der ersten Lagerstelle an dem ersten Ende der geschlossenen Bremskammer von einem Durchmesser der zweiten Lagerstelle an dem zweiten Ende der geschlossenen Bremskammer verschieden ist.

In allen Ausgestaltungen ist es bevorzugt, dass an der äußeren Bremskomponente das Bedienteil ausgebildet oder aufgenommen ist und z. B. als Drehteil, Drehknopf, Mausrad oder Drehrad ausgebildet ist. Vorzugsweise kann das Drehteil z. B. einstückig mit einem Drehknopf oder Drehrad gebildet werden. Bei solchen Ausgestaltungen ist es bevorzugt, dass der Drehknopf bzw. das Drehteil "topf"-förmig ausgebildet ist. Der "Deckel" des Drehteils kann einstückig mit einem als Hülsenteil ausgebildeten Drehteil verbunden sein oder separat daran befestigt werden.

Vorzugsweise umfasst das Bedienteil den äußeren Bremskörper aus einem magnetisch leitenden Material. Der äußere Bremskörper stellt einen Außenring für das Magnetfeld zur Verfügung. Das Magnetfeld zu Erzeugung eines Bremsmomentes tritt quer zur axialen Richtung durch die erste Bremskomponente hindurch und durchtritt den Spalt an den Übertragungselementen, die magnetisch leitend ausgebildet sind. Von den feststehenden oder beweglichen Übertragungselementen oder den drehbaren Wälzkörpern aus tritt das Magnetfeld in den Außenring bzw. in den äußeren Bremskörper ein. Dort verlaufen die Magnetfeldlinien zurück zur anderen Seite der ersten bzw. inneren Bremskomponente und durchtreten (auf der gegenüberliegenden Seite) den Spalt wieder an den Übertragungselementen bzw. Wälzkörpern, bevor die Magnetfeldlinien wieder in die innere Bremskomponente eintreten. Somit liegt ein geschlossener Magnetkreis bzw. es liegen geschlossene Magnetfeldlinien vor.

An den Wälzkörpern bildet sich unter dem Einfluss eines Magnetfeldes bei einer Relativdrehung der ersten und der zweiten Bremskomponente relativ zueinander ein Keileffekt aus, so wie er grundsätzlich in der WO 2012/034697 A1 beschrieben ist. Die Offenbarung dieser Druckschrift wird vollständig mit in diese Anmeldung aufgenommen. Das Bremsmoment bei der vorliegenden Erfindung wird regelmäßig ebenfalls durch den Keileffekt an den feststehenden oder beweglichen Übertragungskomponenten bzw. Wälzkörpern bzw. Drehkörpern erzeugt. Es hat sich erstaunlicherweise gezeigt, dass Wälzkörper nicht immer nötig sind. Das ist insbesondere bei besonders klein bauenden Gerätekomponenten sehr vorteilhaft. Möglich ist ein entsprechender Aufbau auch bei einer Bremswirkung über Scherkräfte ohne den Einsatz von Übertragungskomponenten.

Vorzugsweise ist wenigstens eine radiale Wandstärke des äußeren Bremskörpers wenigstens halb so groß wie eine Spaltbreite des Spaltes und/oder ein Durchmesser einer Übertragungskomponente. Vorzugsweise ist eine radiale Wandstärke des äußeren Bremskörpers größer als 3/4 der Spaltbreite des Spaltes und/oder eines Durchmessers einer Übertragungskomponente. Die radiale Wandstärke des äußeren Bremskörpers kann insbesondere auch größer sein als ein Durchmesser einer Übertragungskomponente. Durch eine genügende Wandstärke des aus einem magnetisch leitenden Materials bestehenden äußeren Bremskörpers kann gewährleistet werden, dass die gewünschte Feldstärke des Magnetfeldes im Bereich der Wälzkörper erzeugt werden kann, um ein hohes Bremsmoment erzeugen zu können.

In allen Ausgestaltungen ist es bevorzugt, dass eine Länge der ersten bzw. inneren Bremskomponente in der axialen Richtung größer ist als eine Länge einer Übertragungskomponente in der axialen Richtung. Wenn die Übertragungskomponente in der axialen Richtung kürzer ausgebildet ist als die erste Bremskomponente führt dies zu einer dreidimensionalen Konzentration des Magnetfeldes im Randbereich der Übertragungskomponente bzw. des Wälzkörpers. Das Magnetfeld kann den Spalt praktisch nur in den Abschnitten durchtreten, in denen sich eine Übertragungskomponente bzw. ein Wälzkörper befindet.

Vorzugsweise ist eine Länge des Spaltes in der axialen Richtung wenigstens doppelt so groß wie eine Länge einer Übertragungskomponente in axialer Richtung. Möglich und bevorzugt ist es auch, dass zwei oder mehr Übertragungskomponenten und insbesondere Wälzkörper in axialer Richtung hintereinander angeordnet sind. Möglich ist es dabei zum Beispiel, dass sich magnetisch leitende Übertragungskomponenten und magnetisch nicht leitende Übertragungskomponenten in axialer Richtung abwechseln, sodass beispielsweise jede zweite oder dritte Übertragungskomponente in axialer Richtung magnetisch nicht leitend ausgebildet ist. Dadurch wird eine Konzentration des Magnetfeldes erzeugt (hohe Feldstärken im Wirkspalt bei den magnetisch leitenden Übertragungskomponenten), die vorteilhaft für das maximal erzeugbare Bremsmoment ist.

In bestimmten Ausgestaltungen ist die erste Bremskomponente im Wesentlichen zylindrisch ausgebildet und umfasst einen zylindrischen Grundkörper als Kern und die elektrische Spule bzw. die elektrischen Spulen. Es können aber auch davon abweichende Formen gewählt werden (Ellipse ...).

Möglich ist es auch, dass beispielsweise eine Kugel zum Lagern eines Drehknopfes oder der Bremseinrichtung der Gerätekomponente umfasst ist, die am distalen Ende zentral angeordnet sein kann, um eine einfache Lagerung zwischen der ersten Bremskomponente und der zweiten Bremskomponente zur Verfügung zu stellen.

Es ist möglich, dass die elektrische Spule wenigstens teilweise in Axialnuten und/oder Quernuten des zylindrischen Statorkörpers der Statoreinheit (der ersten Bremskomponente) gewickelt ist. Vorzugsweise sind die Wicklungen der elektrischen Spule oder das gesamte Bauteil mit Vergussmasse eingegossen. Es ist bevorzugt, eventuell vorhandene Axialnuten und/oder Quernuten wenigstens teilweise mit Vergussmasse zu füllen. Dadurch wird verhindert, dass in den Bereich der Spulendrähte magnetorheologisches Medium bzw. magnetorheologisches Fluid eintritt. Das könnte bei einem magnetorheologischen Fluid zu einer Entmischung des Fluids führen.

Vorzugsweise weist der Tragkörper und/oder die Statoreinheit und vorzugsweise der Statorschaft eine Kabeldurchführung auf. Durch die Kabeldurchführung können Anschlusskabel für die Spule und/oder Sensorkabel und dergleichen mehr geführt werden. Dadurch werden eine leichte Montage und eine kostengünstige Herstellung ermöglicht.

Vorzugsweise weist der Tragkörper eine Aufnahme zur drehfesten Verbindung mit der ersten Bremskomponente auf. Dabei kann der Tragkörper die erste Bremskomponente kraftschlüssig und/oder formschlüssig aufnehmen. Im Betrieb wird das Bremsmoment zwischen der ersten Bremskomponente und der zweiten Bremskomponente über den Tragkörper abgeführt.

Vorzugsweise weist die Statoreinheit eine zylindrische Aufnahme für eine Lagereinheit auf und stützt die zweite Bremskomponente drehbar auf der Statoreinheit ab.

An der zylindrischen Lauffläche ist vorzugsweise die Dichtung zum Abdichten des Spaltes angeordnet, wobei die Dichtung insbesondere näher an dem Spalt angeordnet ist als die Lagereinheit. Dadurch wird die Lagereinheit zuverlässig vor dem magnetorheologischen Medium geschützt. Eine solche Ausgestaltung ermöglicht einen kompakten Aufbau und einen zuverlässigen Betrieb. Die Lagereinheit kann z. B. ein Gleit- oder Wälzlager sein.

Die haptische Bedieneinrichtung kann an einer Konsole oder auch an anderen Teilen befestigt sein.

Vorzugsweise ist eine relative Winkelstellung oder auch eine absolute Winkelstellung erfassbar. Vorzugsweise ist eine Genauigkeit besser als 1° und insbesondere besser als 0,5° und besonders bevorzugt besser als 0,2° oder 0,1°.

Vorzugsweise ist eine Benutzerschnittstelle, ein Bedienpanel, ein Display, ein berührungsempfindliches Display mit oder ohne haptischem Feedback und/oder wenigstens ein Sensor angebracht. Eine solche Ausgestaltung ermöglicht neben der Bedienung auch gleichzeitig die Anzeige oder Ausgabe von Informationen während der Bedienung. Damit wird beispielsweise ein Bedienknopf mit gleichzeitigem Ausgabedisplay ermöglicht.

In allen Ausgestaltungen ist es möglich, dass an dem Tragkörper oder der Statoreinheit ein druckempfindlicher Sensor angebracht ist oder der Statoreinheit ein solcher Sensor zugeordnet ist. Beispielsweise kann in der Statoreinheit ein druckempfindlicher Sensor angebracht sein. Möglich ist es aber auch, dass ein Piezo-Sensor am Unterteil der Statoreinheit oder an der Konsole etc. angebracht ist. Es kann auch eine axiale Verschiebung der beiden Bremskomponenten gegeneinander registriert werden. Dabei kann eine haptische Rückmeldung erfolgen.

In allen Ausgestaltungen ist es bevorzugt, dass eine Differenz zwischen einem lichten Innendurchmesser des äußeren Bremskörpers und einem minimalen Außendurchmesser der ersten Bremskomponente größer 1 oder 2 oder 3 mm und kleiner 50 mm beträgt. Es ist ebenso bevorzugt, dass ein Außendurchmesser des äußeren Bremskörpers zwischen 5 mm oder 10 mm und 90 mm beträgt.

Vorzugsweise beträgt eine Höhe des Bedienteils zwischen 5 mm und 100 mm. In allen Ausgestaltungen ist es bevorzugt, dass eine Steuereinrichtung umfasst ist, welche dazu ausgebildet ist, mit der elektrischen Spule eine variable und gezielt steuerbare Bremswirkung hervorzurufen.

Insgesamt arbeitet die vorliegende Erfindung besonders bevorzugt nach dem Grundprinzip der Keilklemmung, wobei eine Übertragungskomponente mit einem gewissen Abstand an den Wänden entlang streift oder gegebenenfalls darauf abrollt. Durch ein Magnetfeld entsteht der Keileffekt, sodass ein hohes Bremsmoment erzeugbar ist. Vorzugsweise wird ein Magnetfeld quer zu (dem Kern) der ersten Bremskomponente erzeugt. Dabei können durch die radial vergrößerte elektrische Spule höhere Bremsmomente bei kleinerer Baugröße erzeugt werden. Durch den Einsatz dieser axialen Spule kann eine bessere Skalierbarkeit erreicht werden. Dadurch wird es möglich, mittels längerer Wälzkörper und einer axial längeren elektrischen Spule ein skalierbares und größeres Bremsmoment oder bei kurzer Bauweise ein entsprechend kleineres Bremsmoment erzeugt. Dabei muss der Durchmesser der ersten Bremskomponente nicht größer gewählt werden, um ein entsprechendes Magnetfeld durchzuleiten, denn mit einer axialen Anpassung des Kerns wird auch die Fläche des Kerns (Querschnittsfläche) größer. Gegebenenfalls kann die axiale Länge auch reduziert werden, wenn nur ein relativ geringes Bremsmoment benötigt wird. Der Bauraum kann dementsprechend angepasst werden.

Ein weiterer Vorteil ist, dass auch für eine Großserie das Herausführen des elektrischen Anschlusskabels für die elektrische Spule einfach möglich ist. Es kann über einfache Mittel eine Dichtheit der magnetorheologischen Bremseinrichtung und ein Skalieren ermöglicht werden.

Grundsätzlich kann über längere Wälzkörper ein größeres Moment von der magnetorheologischen Bremseinrichtung erzeugt werden, da die Wirklänge steigt. Durch die nochmals erheblich größere Kernfläche wird gewährleistet, dass die Übertragungskomponenten immer einer entsprechenden magnetischen Flussdichte ausgesetzt werden. Die Magnetfeldstärke beim "Keil" an der Übertragungskomponente kann höher gewählt werden als im Stand der Technik. Es können lang ausgebildete Übertragungskomponenten eingesetzt werden, denen ein genügend starkes Magnetfeld zugeleitet werden kann.

Insbesondere geht das von der elektrischen Spule erzeugte Magnetfeld radial durch den Kern, dann durch die Wälzkörper und schließt sich über das (Hülsenteil bzw.) den äußeren Bremskörper. Dabei schließen sich die Magnetfeldlinien einmal in der einen und z. B. unteren bzw. linken und einmal in der anderen und z. B. oberen bzw. rechten Hälfte des äußeren Bremskörpers. Die Wege sind somit kurz, was eine bessere Ansprechzeit (geringere Induktivität bzw. Zeitkonstante (Tau)) zur Folge hat. In einfachen Ausgestaltungen verläuft der Magnetfluss somit im Wesentlichen zweidimensional. Dabei ist es egal, wie lang, kurz oder hoch die Übertragungskomponenten ausgebildet werden. Dadurch kann eine beliebige Skalierung in der Länge erreicht werden, da die Magnetfeldübertragungsfläche mit wächst. Bei konzentrisch um die Längsrichtung der ersten Bremskomponente gewickelten elektrischen Spulen (Stand der Technik) bleibt die Querschnittsfläche im Kern hingegen immer gleich und bildet insofern ein Nadelöhr für das Magnetfeld, solange der Durchmesser nicht verändert wird. Ein größerer Durchmesser der ersten Bremskomponente ändert aber auch den Bauraumbedarf, die Einbauabmessungen und das Gewicht der magnetorheologischen Bremseinrichtung. Außerdem ändern sich die Momentenabstände und die Drehzahlen der Wälzkörper, was nicht immer vorteilhaft ist. Bei Vergrößerung des verfügbaren Kernquerschnittes und einer linearen Verlängerung wie bei der vorliegenden Erfindung ändert sich dies hingegen nicht.

Werden längere Wälzkörper eingesetzt, so kann der Bremseffekt einer langen Walze besser sein als bei zwei kurzen, die die gleiche Gesamtlänge aufweisen. Das liegt unter anderem daran, dass die Flüssigkeit abstandsmässig länger verdrängt werden muss, da der Rand weiter entfernt ist (hydrodynamischer Druck).

In bevorzugten Ausgestaltungen weist die magnetorheologische Bremseinrichtung einen Durchmesser des äußeren Bremskörpers (und somit der zweiten Bremseinrichtung) von zwischen etwa 5 und 40 mm (+/- 20%) auf und in bevorzugten Ausgestaltungen etwa 7 oder 10 bis 20 mm.

Ingesamt stellt die Erfindung eine vorteilhafte haptische Bedieneinrichtung mit einer magnetorheologischen Bremseinrichtung ("MR Bremse") zur Verfügung. Dabei ist der Außendurchmesser der MR Bremse besonders bei haptischen Anwendungen meist vorgegeben. Hier gibt es ergonomische Richtlinien oder Bauraumvorgaben. Deshalb kann der Kernquerschnitt generell nicht so einfach vergrößert werden, weil damit der Außendurchmesser auch größer wird (Knopfaußendurchmesser; Fläche für die Finger). Zudem benötigt man mit größer werdendem Außendurchmesser wieder mehr Sperrmoment, da der Momentenabstand deswegen größer wurde. Die Fingerkraft, also die (Tangential)kraft zwischen den Betätigungsfinger(n) und dem Bremselement bzw. der Außenoberfläche des Bremselements muss bzw. sollte gleich bleiben, da einerseits vom Benutzer nur eine bestimmte Kraft aufgebracht werden kann und die notwendigen Kräfte an den Fingern (Fingerspitzen) für das Wohlbefinden bei der Betätigung (Bedienqualität) wichtig sind.

Die Erfindung erreicht das Ziel, eine möglichst einfache aber dennoch gut skalierbare haptische Bedieneinrichtung mit hohem Bremsmoment bei einem kompakten Außendurchmesser zu erhalten.

Ein Vergießen der Elektrospule ist vorteilhaft, damit die MR-Flüssigkeit (Trägerflüssigkeit) nicht in die Leerräume zwischen den Spulendrähten gelangt (Kapillareffekt). Dies kann sonst zum Entmischen führen. Statt eines (zylindrischen) Spulendrahts kann auch ein Flachmaterial aus Kupfer oder einem anderen geeigneten Werkstoff verwendet werden.

Der Kern, die Walzkörper und der äußere Bremskörper können aus einem einfachen Stahl (z. B. S235), ohne große Anforderungen an die Oberflächenbeschaffenheit und -härte, gefertigt sein, welcher vorzugsweise gute magnetische Eigenschaften aufweist. Es können aber auch (mehrere übereinander gestapelte) Walzkörper oder Kugeln oder anders geformte Übertragungskomponenten verwendet werden. Es können Abstandshalter (Leitblech) zwischen den Wälzkörpern vorhanden sein.

Der noch neben der elektrischen Spule verfügbare Raum (Spalt) zwischen Kern und Außenzylinder muss nicht zwingend (nahezu) komplett mit Walzkörpern gefüllt sein. Es können auch Distanzhalter zwischen den Walzkörpern oder ein oder mehrere Walzkörper oder Übertragungskomponenten aus magnetisch nicht leitendem Material - zusammen mit Walzkörpern oder Übertragungskomponenten aus magnetisch leitendem Material - verwendet werden.

Das Gegendrehmoment kann an z. B. eine Konsole, Grundplatte, Aufnahmeplatte, Gehäuse oder ein anderes Bauteil abgeleitet werden. Die Statoreinheit hat vorzugsweise eine Bohrung, durch welche die Kabel geführt werden. Vorzugsweise dichtet ein Dichtelement (z. B. O- Ring) das Kabel gegenüber der Statoreinheit bzw. dem Innenraum ab, sodass vom Innenraum keine Flüssigkeit über das Kabel nach außen gelangen kann. Zusätzlich zum (Spulen-)Kabel kann auch ein Temperatursensorkabel oder anderes Sensorkabel durch diese Öffnung geführt werden.

Der Statorkörper kann auch aus einem anderen Material wie der Kern, Walzkörper oder der äußere Bremskörper hergestellt sein. Die bevorzugte Walzkörperhöhe liegt zwischen 3 und 6 mm, kann aber auch 1 oder 2 mm sein.

Über dem äußeren Bremskörper kann ein dekoratives Element oder ein anderes Bedienelement angebracht werden, z. B. ein gummierter Knopf oder ein Reibrad oder ein spezieller Rändel oder dergleichen.

Vorzugsweise besteht zumindest eine vom Magnetfeld durchflossene Komponente wenigstens teilweise oder vollständig aus dem Werkstoff FeSi3P.

In besonders bevorzugten Weiterbildungen der haptischen Bedieneinrichtung ist die äußere Bremskomponente für ihre Drehbarkeit um die innere Bremskomponente mittels wenigstens einer Lagereinheit wenigstens einer Lagereinrichtung an dem Tragkörper gelagert ist, sodass mit der Lagereinheit eine von der inneren Bremskomponente unabhängige Lagerung der äußeren Bremskomponente erfolgt.

Vorzugsweise ist die Rotoreinheit für ihre Drehbarkeit um die Statoreinheit mittels wenigstens einer Lagereinheit wenigstens einer Lagereinrichtung an dem Tragkörper gelagert, sodass mit der Lagereinheit eine von der Statoreinheit unabhängige Lagerung der Rotoreinheit erfolgt.

Insbesondere ist die äußere Bremskomponente mittels der Lagereinheit nach radial außen an dem Tragkörper gelagert.

Es ist vorteilhaft, wenn die Lagereinheit an einer radialen Außenseite der äußeren Bremskomponente angeordnet ist und wenn die äußere Bremskomponente wenigstens teilweise zwischen der Lagereinheit und der inneren Bremskomponente angeordnet ist.

Vorzugsweise umgibt die Lagereinheit die äußere Bremskomponente nur teilweise radial. Vorzugsweise umgibt die Lagereinheit die äußere Bremskomponente formschlüssig radial, sodass die äußere Bremskomponente die Lagereinheit in radialer Richtung nicht verlassen kann. Insbesondere ist die äußere Bremskomponente dabei nur mit einem radialen Teilabschnitt ihres Umfangs an dem Tragkörper gelagert.

Vorzugsweise ist die äußere Bremskomponente nicht an der inneren Bremskomponente und vorzugsweise nur an dem Tragkörper gelagert.

Es ist möglich und bevorzugt, dass wenigstens eine Lagereinheit wenigstens ein Festlager zum Blockieren einer axialen Bewegbarkeit der äußeren Bremskomponente bereitstellt und/oder dass der wenigstens einen Lagereinheit wenigstens eine Wegbegrenzung für eine axiale Bewegbarkeit der äußeren Bremskomponente in wenigstens einer Richtung zugeordnet ist.

Insbesondere ist ein Schaft der inneren Bremskomponente mittels wenigstens eines Schafthalters an dem Tragkörper angeordnet ist.

Vorzugsweise ist die Statoreinheit drehfest an dem Schafthalter angeordnet. Insbesondere ist der Schafthalter axial verschiebbar an dem Tragkörper angeordnet und der Schafthalter umgibt die äußere Bremskomponente wenigstens abschnittsweise radial.

Es ist bevorzugt, dass die äußere Bremskomponente axial verschiebbar an dem Tragkörper gelagert ist.

Insbesondere ist die innere Bremskomponente nur einseitig an dem Tragkörper befestigt und/oder ist nur mit einem Endabschnitt des Schafts an dem Tragkörper befestigt.

Vorzugsweise ist wenigstens eine Ausrichtungseinrichtung zum Ausrichten einer axialen Mittelachse der inneren Bremskomponente umfasst, insbesondere zum Ausrichten des Schafts relativ zu einer axialen Mittelachse bzw. Drehachse der äußeren Bremskomponente.

Vorzugsweise ist mittels der Ausrichtungseinrichtung wenigstens ein Schaft der inneren Bremskomponente an dem Schafthalter ausrichtbar. Insbesondere umfasst der Schaft dazu wenigstens einen konischen Ausrichtungsabschnitt, welcher in und/oder an einem korrespondieren konischen Ausrichtungsteil des Schafthalters angeordnet ist.

Es ist vorteilhaft, wenn mittels der Ausrichtungseinrichtung der Schafthalter an dem Tragkörper und/oder die äußere Bremskomponente an dem Schafthalter ausrichtbar ist.

Insbesondere ist der Schafthalter dazu wenigstens teilweise achsensymmetrisch ausgebildet ist, sodass eine axiale Mittelachse eines Abschnitts des Schafthalters, welcher die äußere Bremskomponente radial umgibt, und eine axiale Mittelachse eines Abschnitts des Schafthalters, an welchem die innere Bremskomponente befestigt ist, parallel und insbesondere überdeckend angeordnet sind.

Die äußere Bremskomponente kann an einem Abschnitt des Schafthalters, welcher die äußere Bremskomponente radial umgibt, drehbar gelagert sein.

Vorzugsweise umgibt ein Abschnitt des Schafthalters die äußere Bremskomponente radial und ist mit seiner Außenseite wenigstens teilweise in dem Tragkörper angeordnet und ist vorzugsweise dort drehfest angeordnet.

Insbesondere ist ein bei einer Verzögerung der Drehbewegung der äußeren Bremskomponente auftretendes Verzögerungsmoment über die innere Bremskomponente in den Tragkörper ableitbar.

Eine im Rahmen eines Bedienvorgangs auf die äußere Bremskomponente ausgeübte Druckbelastung ist insbesondere wenigstens über die Lagereinheit unter Umgehung der inneren Bremskomponente in den Tragkörper ableitbar.

Die Lagereinrichtung umfasst insbesondere wenigstens eine weitere Lagereinheit und die äußere Bremskomponente ist insbesondere auch mittels der wenigstens einen weiteren Lagereinheit an dem Tragkörper gelagert.

Die äußere Bremskomponente umfasst wenigstens ein Bedienrad oder ist als ein solches ausgebildet. Das Bedienrad ist vorzugsweise eine Fingerwalze und besonders bevorzugt ein Mausrad.

Das magnetorheologische Medium umfasst insbesondere mittels eines Magnetfelds gezielt beeinflussbare Partikel. Insbesondere sind die Partikel in einem Trägermedium aufgenommen sind. Insbesondere wird das Trägermedium durch Umgebungsluft und/oder ein sich von der Umgebungsluft unterscheidendes Fluid bereitgestellt wird. Das Trägermedium kann sich wenigstens auch durch den Druck von der Umgebungsluft unterscheiden. Zum Beispiel können die Partikel mit einem Unterdruck beaufschlagt bzw. unter einem Vakuum in einem Fluid oder auch in der Umgebungsluft oder Gasgemisch aufgenommen sein. Insbesondere ist zwischen der Rotoreinheit und der Statoreinheit ein Raum bzw. Spalt für das magnetorheologische Medium angeordnet, welcher an das jeweilige Medium angepasst ist. Vorzugsweise ist die Dichtung dazu geeignet und ausgebildet, den Spalt für ein solches magnetorheologisches Medium und beispielsweise für Partikel in Luft als Medium und/oder in einem flüssigen Medium nach außen abzudichten.

Insbesondere sind ferromagnetische und/oder ferrimagnetische und/oder superparamagnetische Partikel und vorzugsweise wenigstens Partikel aus Carbonyleisenpulver vorgesehen. Besonders vorteilhaft kann in der hier gezeigten Bedieneinrichtung ein magnetorheologisches Medium eingesetzt werden, welches aus Carbonyleisenpulver in Umgebungsluft bereitgestellt wird. Dazu können noch Hilfsstoffe kommen, welche insbesondere die Schmierung verbessern. Insbesondere weisen die Partikel eine Verteilung der Partikelgröße zwischen einem und zwanzig Mikrometern auf. Möglich sind auch kleinere (< 1 Mikrometer) bis sehr kleine (wenige Nanometer, typischerweise 5 bis 10 Nanometer) oder größere Partikel von dreißig, vierzig und fünfzig Mikrometer.

In einer bevorzugten Weiterbildung umfasst die Bedieneinrichtung eine Steuereinrichtung, welche dazu geeignet und ausgebildet ist, die Drehbewegung des Bedienteils mittels der insbesondere magnetorheologischen Bremseinrichtung in Abhängigkeit eines Betriebszustands eines Kraftfahrzeugs zu bremsen. Vorzugsweise umfasst der Betriebszustand wenigstens einen Fahrbetrieb und wenigstens einen Standbetrieb. Der Standbetrieb umfasst insbesondere wenigstens einen Aufladebetrieb für eine Traktionsbatterie eines wenigstens teilweise elektrisch betriebenen Fahrzeugs.

Insbesondere ist die Steuereinrichtung dazu geeignet und ausgebildet, in Abhängigkeit des Betriebszustands automatisch und vorzugsweise unter Verwendung eines Algorithmus des maschinellen Lernens eine Funktionsebene auszuwählen und einzustellen oder vorzuschlagen, welche mit dem Bedienteil bedient werden kann. Insbesondere umfasst die Funktionsebene wenigstens eine Unterhaltungsfunktion. Insbesondere wird die Unterhaltungsfunktion in Abhängigkeit des Standbetriebs ausgewählt. Insbesondere umfasst die Funktionsebene wenigstens eine Fahrassistenzfunktion. Insbesondere wird die Fahrassistenzfunktion in Abhängigkeit des Fahrbetriebs ausgewählt.

Es ist bevorzugt und vorteilhaft, dass die Steuereinrichtung dazu geeignet und ausgebildet ist, in Abhängigkeit des Betriebszustands automatisch und vorzugsweise unter Verwendung des Algorithmus des maschinellen Lernens eine Funktionsebene zu sperren und/oder nicht vorzuschlagen. Insbesondere werden in Abhängigkeit des Fahrbetriebs gezielt solche Funktionsebenen gesperrt und/oder nicht vorgeschlagen, welche zur Ablenkung des Fahrers geeignet sind und/oder welche während der Fahrt gesetzlich verboten sind. Insbesondere ist in der Steuereinrichtung hinterlegbar, welche Funktionsebenen gesperrt und/oder nicht vorgeschlagen werden sollen.

Solche Weiterbildungen können rein beispeilhaft wie folgt ausgeführt werden (dabei können einzelne Merkmale auch für sich genommen oder in beliebiger Kombination miteinander umgesetzt werden): Elektro-/Hybridfahrzeuge benötigen mehr Zeit zum Tanken (Laden) als Verbrennungsmotorenfahrzeuge. Je nach Ladestruktur und Batteriegröße können dies auch mehrere Stunden sein. Selbst bei Schnellladestationen (800 Volt) dauert das Laden merklich länger als beim Tanken mit fossilem Treibstoff. Ein Kraftfahrzeug ist mit vielen Bedienelementen ausgerüstet, welche wenigstens teilweise wie das hier beschriebene Bedienteil ausgebildet sind. Während des Ladevorgangs (Standbetrieb) werden die adaptiven (magnetorheologischen) Bedienteile im Fahrzeug haptisch so angesteuert, dass sich der Fahrer damit die Zeit vertreiben oder arbeiten kann (Einstellung von Unterhaltungsfunktionen). Das Autos samt den Bedienteilen wird dann zum Büro oder zur Gamingstation. Zum Beispiel kann ein als Drehrad bzw. Daumenwalze ausgebildetes Bedienteil im Lenkrad oder in der Mittelkonsole als Computermausrad verwendet werden, das Headup-, Armaturendisplay oder die anderen (Touch-) Displays als Anzeigeeinheit, die Beleuchtung um Effekte zu machen und die Spracheingabe um z.B. Texte zu diktieren. Selbst ein Multifunktionssitz (dessen Massagefunktion) oder das Fahrwerk kann miteinbezogen werden (z.B. Luftfahrwerk von einem Auto oder LKW) und bestimmte Spielzustände realistischer nachzustellen. Der Blinker-, Ganghebel, (Schlat-) Wippen bzw. Pedale zum Steuerelement in Spielen, die (by wire) Pedalerie zum Steuern eines Autos in einem Gamingspiel (z. B. Need for Speed...), und das Lenkrad, besonders bei Autos mit Steer by wire, oder alles zusammen als Flugsimulatorbedienung/-spiel. Hierfür muss die Haptik (Force Feedback) d. h. die Kraft über Weg oder das Drehmoment über Winkel entsprechend den Anforderungen variabel eingestellt und angepasst werden (insbesondere von der Steuereinrichtung, welche die Bremseinrichtung gezielt ansteuert). Das haptische Feedback der Daumenwalze im Lenkrad wird dahingehend erweitert, dass z. B. in Zusammenhang mit einer Office Anwendung (PC) leichter durch Seiten gescrollte werden kann, beim Seitenumbruch ein kurze Krafterhöhung am Benutzerfinger spürbar ist. Das Eingaberad lässt sich am Ende von Seiten, am Ende der Ansicht, beim Zoommaximum/Minimum, am Ende von Listen etc. schwerer drehen (stoppt). Es wird beim Aufsuchen verbotener Seiten gesperrt (z. B. als Kindersicherung im Internet). Die Rasterung des Eingaberades ist ein- und ausschaltbar und die Stärke der Rasterung veränderbar. Die Rasterweite kann der Benutzer beliebig einstellen. Dateiordner- und Dateigrößen werden durch mehr Widerstand beim Verschieben angezeigt. Beim Durchscrollen von Ordnern ist der Widerstand größer bei großen Ordnern, kleiner bei kleinen und einzelnen Dateien. Die Daumenwalze, welche zu einem Mausrad wird, kann ihr Scrollverhalten verändern, wenn sich der Cursor einem gewünschten (favorisierten) Punkt nähert (oder fixen Punkten, in konstantem Abstand etc.). Wird das Mausrad für Gaming genutzt, so sollte das Drehmoment generell reduziert werden (z.B. kleiner 1 Nm), weil hierfür das adaptive Drehrad zeitlich viel länger benutzt wird als für das Einstellen eines Menüs beim Autofahren, also anstrengender ist. Beim Autofahren bzw. im Fahrbetrieb sollten die Bedienelemente ein wenig schwerer gehen (höheres Drehmoment oder Kraft; z.B. 2 Nm oder mehr), da das Fahrzeug Erschütterungen ausgesetzt ist und das Autofahren ein dynamischer Vorgang (von außen wirken Kräfte ein) ist. So können sichere Benutzereingaben erzeugt werden. Das Benutzen der Bedienelement im Stand bzw. beim Laden der Batterie ist ein gesamtstatischer Vorgang, bei welchem das Bedienelement lange und intensiv, aber in ruhiger Umgebung, genutzt wird. Zu hohe Kräfte oder Momente führen hierbei zur schnelleren Ermüdung der Eingabeelemente (Finger, Hand, Fuß) und bei sehr intensiver Eingabe mitunter zu Entzündungen (z.B. Sehnenscheidenentzündung). Zudem muss in Spielen oder Officeanwendung das Drehmoment feiner und mehrstufiger (vielfältiger) und mit haptische anderen Kurvenverläufen variiert werden als beim Bedienen des Autos. Die Modi sind insbesondere bei der Nutzung als nicht fahrspezifisches Bedienelement programmierbar, so dass jeder Anwender seine eigenen Ideen umsetzen kann. Dazu kann ein einfaches App zum Anpassen individueller haptischer Rückmeldungen implementiert sein. Auch kann die Haptik im Fahrzeug von der Spielkonsole zu Hause oder dem PC im Büro übernommen werden (z.B. Einstellungen werden in der Cloud gespeichert und übernommen). Die Haptik sollte aber bei fahrspezifischen Eingaben wieder in einen Standardmode gehen, damit der Fahrzeugfahrer hier ein reproduzierbares Feedback für Fahrereignisse erhält, besonders wenn diese sicherheitsrelevant sind (z.B. Tempomat, Abstandskontrolle, Gas, Bremse...). Obiges ist auch für die hinteren Plätze im Auto von Vorteil. Auch dort können die adaptiven Drehsteller für die Lüftung oder die Eingabegeräte für die Klimatisierung haptisch zu Eingabegeräten für das Spielen verwendet werden. Z. B. Kinder können so beim Laden der Batterie aber auch beim Fahren die schon vorhandenen Bedienelemente multifunktional nutzen und sich so die Zeit vertreiben. Das Fahrzeug kann aber auch in der Garage als "Spielsimulator" oder als "Fahrschulsimulator" verwendet werden, es muss nicht nur beim Laden der Batterie sein. Solche Ausführungen können auch für andere Fahrzeuge wie Lastkraftwagen, OFF-Highwayfahrzeuge, Motorräder, Pistenfahrzeuge, Flugzeuge, Fahrräder..., also Vehikel, welche Bedienelemente haben, die sich adaptiv anpassen lassen.

Weitere Vorteile und Merkmale der vorliegenden Erfindung ergeben sich aus den Ausführungsbeispielen, welche im Folgenden mit Bezug auf die beiliegenden Figuren erläutert werden.

In den Figuren zeigen:
- Fig. 1a-1f: schematische dreidimensionale Ansichten von haptischen Bedieneinrichtungen mit einer magnetorheologischen Bremseinrichtung;
- Fig. 2: einen stark schematischen Querschnitt durch einen Wälzkörper einer magnetorheologischen Bremseinrichtung;
- Fig. 3: einen schematischen Querschnitt durch eine haptische Bedieneinrichtung mit einer magnetorheologischen Bremseinrichtung;
- Fig. 4a-4c: verschiedene Querschnitte weiterer haptischer Bedieneinrichtungen;
- Fig. 5a-5e: rein schematische Darstellungen weiterer Ausgestaltungen der haptischen Bedieneinrichtung in geschnittenen Seitenansichten;
- Fig. 6-12: schematische Gesamt- und Detaildarstellungen einer weiteren haptischen Bedieneinrichtung;
- Fig. 13a-e: rein schematische Darstellungen der Bewegbarkeit des Bedienteils durch die magnetorheologische Bremseinrichtung bei Betätigung des Bedienteils.

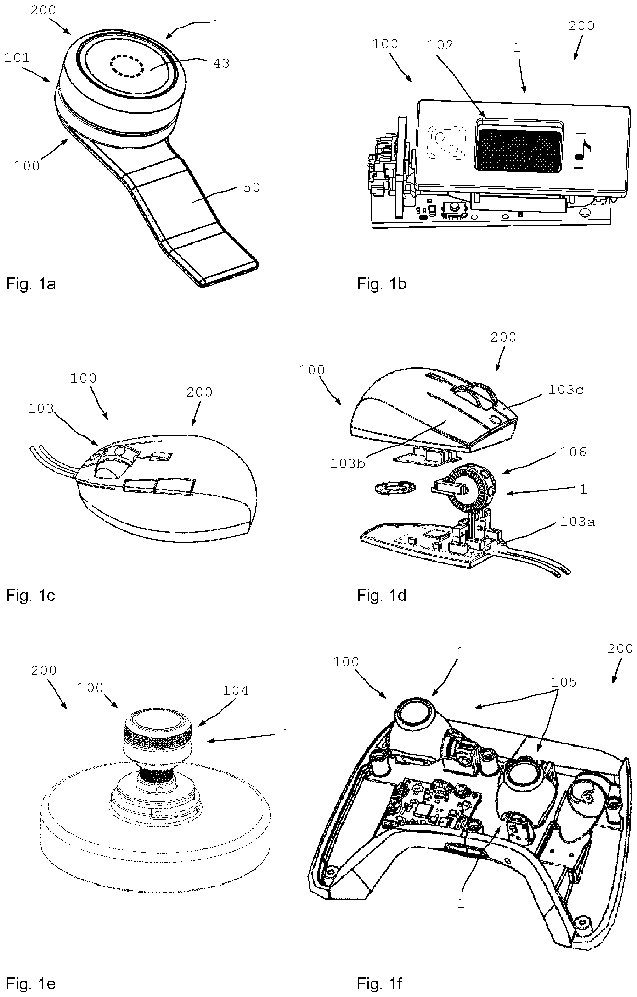

Figuren 1a bis 1f zeigen mehrere haptische Bedieneinrichtungen 100 bzw. Gerätekomponenten 200, an denen jeweils wenigstens eine magnetorheologische Bremseinrichtung 1 und wenigstens ein Bedienteil 101 eingesetzt werden kann.

Figur 1a zeigt eine als haptischen Bedienknopf ausgeführte haptische Bedieneinrichtung 100. Der Bedienknopf ist über die Konsole oder einen Tragkörper 50 befestigt. Der Bedienknopf 101 wird durch Drehung des Bedienteils 101 bedient. Die Benutzerschnittstelle 43 kann zusätzlich genutzt werden, um Informationen zu übermitteln.

In Figur 1b ist die Gerätekomponente 200 als haptische Bedieneinrichtung 100 mit einer Daumenwalze 102 dargestellt. Die Daumenwalze 102 ist bevorzugt beispielsweise in Lenkrädern von Fahrzeugen einsetzbar. Die Daumenwalze ist jedoch nicht auf diesen Anwendungsfall beschränkt. Die Daumenwalze 102 kann allgemein je nach Einbausituation auch mit jedem anderen Finger nutzbar sein.

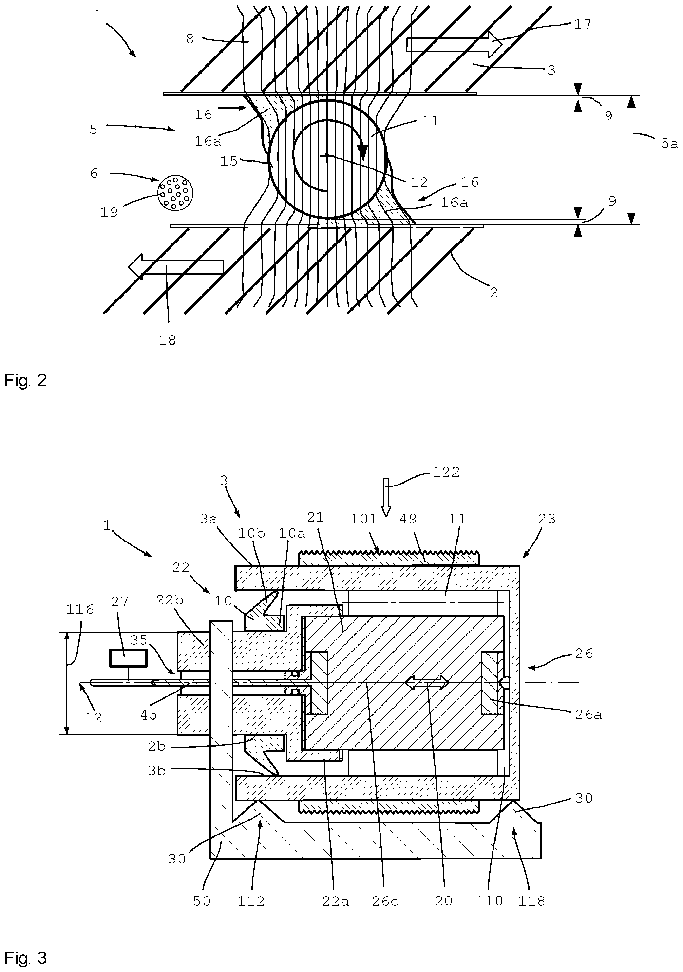

Wenn das Bedienteil 101 bzw. die Daumenwalze nicht bedient wird, können Vibrationen von zum Beispiel einem Fahrzeug darauf übertragen werden. So können Vibrationen von dem fahrenden Fahrzeug auf das Lenkrad oder die Mittelkonsole übertragen werden. Dann kann es z. B. passieren, dass sich das Bedienteil oder die die Daumenwalze ungewollt durch die Vibrationen bewegt. Damit das nicht passiert, kann die elektrische Spule 26a (vgl. Fig. 3) der Daumenwalze bei Nichtbenutzung leicht bestromt werden, wodurch praktisch eine Erhöhung des Grundmoments bewirkt wird. Die Software überwacht dabei das Bedienteil 101. Wenn sich der Drehwinkel des Bedienteils 101 (Drehknopfes, Daumenrad, Daumenwalze etc.) auch bei leichter Bestromung noch weiter ändert, dann ist es der Benutzer, der das Bedienteil 101 drehen will. Die Software gibt dann das Bedienteil 101 zum Drehen frei und die Winkeländerung wird dann weiter gegeben (Eingabe). Eine Berührungs- oder Nahfeldsensorik kann verwendet werden, damit die Steuerung weiß, wann die Drehung vom Benutzer kommt und wann nicht. Das ist vor allem dann sinnvoll, wenn solche Sensoren schon verbaut wurden. Ein geringer Nachteil ist ein leicht erhöhter Stromverbrauch und ein leicht erhöhtes Grundmoment (Festkleben des Knopfes) am Anfang der Drehung.

In Figur 1c und Figur 1d ist die haptische Bedieneinrichtung 100 als Computermaus 103 ausgeführt. Die steuerbare magnetorheologische Bremseinrichtung 1 der haptischen Bedieneinrichtung 100 ist in dem Mausrad 106 untergebracht. Das Mausrad 106 dient als Bedienteil 101 oder ist damit verbunden oder gekoppelt. Die magnetorheologische Bremseinrichtung 1 kann genutzt werden, um ein haptisches Feedback zu steuern.

Figur 1e zeigt einen Joystick 104 als haptische Bedieneinrichtung 100, in welchem eine magnetorheologische Bremseinrichtung 1 untergebracht ist. Außerdem ist die magnetorheologische Bremseinrichtung 100 auch in einem Gamepad 105 bevorzugt nutzbar, um dem Spieler in Abhängigkeit der Spielsituation ein haptisches Feedback zu geben.

In diesen Ausführungsbeispielen weist die magnetorheologische Bremseinrichtung 1 ein drehbares Bedienteil 101 auf. Das zur Drehung des Bedienteil 101 erforderliche Drehmoment ist über die magnetorheologische Bremseinrichtung 1 einstellbar.

Auf der Oberseite der haptischen Bedieneinrichtung 100 kann eine Benutzerschnittstelle 43 angeordnet sein. Eine solche Benutzerschnittstelle 43 kann beispielsweise als Anzeigeeinrichtung oder auch als berührungsempfindliche Eingabemöglichkeit (Touchpad, Bewegungs- und Gestensteuerung, Bilderkennung ...) ausgebildet sein.

Eine haptische Bedieneinrichtung 100 kann beispielsweise zur Bedienung von Maschinen, Medizingeräten oder zur Verwendung im und für das Kraftfahrzeug eingesetzt werden. Möglich ist auch der Einsatz an sonstigen Geräten oder anderen Vorrichtungen.

Figur 2 zeigt eine stark schematische Querschnittsansicht einer magnetorheologischen Bremseinrichtung 1 zur Beeinflussung der Kraftübertragung zwischen zwei Bremskomponenten 2 und 3. Dabei ist zwischen den zwei Bremskomponenten 2 und 3 in Fig. 2 ein Wälzkörper bzw. Drehkörper 11 vorgesehen. Der Wälzkörper 11 ist hier als Kugel oder Walze 15 ausgebildet. Möglich ist es aber ebenso, Wälzkörper 11 als Zylinder oder Ellipsoide, Rollen oder sonstige rotierbare Drehkörper auszubilden. Auch im eigentlichen Sinn nicht rotationssymmetrische Drehkörper wie beispielsweise ein Zahnrad oder Drehkörper 11 mit einer bestimmten Oberflächenstruktur können als Wälzkörper verwendet werden.

Denkbar ist es in allen Ausgestaltungen und Ausführungen auch, dass einzelne oder alle Wälzkörper 11 (nicht nur zur Übertragung von Drehmoment, sondern auch) zur Lagerung der Bremskomponenten 2 und 3 relativ zueinander eingesetzt werden, sodass eine separate Lagereinrichtung 30 oder separate Lagerstellen nicht benötigt werden. In besonders einfachen Ausführungen kann das über Wälzkörper 11 in Form von z. B. Walzen aus einem nicht oder nahezu nicht magnetisch leitfähigen Material erfolgen.

Zwischen den Bremskomponenten 2 und 3 ist ein Kanal oder Spalt 5 vorgesehen, der über eine Spaltbreite 5a verfügt und hier mit einem Medium 6 gefüllt ist. Das Medium ist hier ein magnetorheologisches Fluid, welches beispielsweise als Trägerflüssigkeit ein Öl umfasst, in dem ferromagnetische Partikel 19 vorhanden sind. Glykol, Fett, Silikon, Wasser, Wachs und dickflüssige oder dünnflüssige Stoffe können auch als Trägermedium verwendet werden, ohne darauf beschränkt zu sein. Das Trägermedium kann auch gasförmig und/oder ein Gasgemisch sein (z. B. Luft bzw. Umgebungsluft, Stickstoff, Gas oder Gasgemisch, Luftgemisch) bzw. es kann auf das Trägermedium verzichtet werden (Vakuum oder Luft und z. B. Umgebungsluft). In diesem Fall werden lediglich durch das Magnetfeld beeinflussbare Partikel (z. B. Carbonyleisen) in den Wirkspalt (Spalt) bzw. Kanal gefüllt. Eine Vermischung mit anderen - vorzugsweise mit schmierenden Eigenschaften - Partikel wie Grafit, Molybdän, Kunststoffpartikeln, polymere Materialien sind möglich. Es kann auch eine Kombination aus den genannten Materialien sein (z.B. Carbonyleisenpulver vermischt mit Graphit und Luft als Trägermedium). Als Carbonyleisenpulver ohne (flüssiges) Trägermedium kann zum Beispiel von der Firma BASF das Pulver mit der Bezeichnung CIP ER verwendet werden mit einem Mindestanteil an Eisen von 97%, ohne Beschichtung und einer Durchschnittsgröße der Partikel von 5,1µm, oder auch das CIP SQ-R von BASF mit mindestens 98,5% Eisenanteil, 4,5um Durchschnittsgröße und SiO2-Beschichtung. Die verschiedenen Pulver unterscheiden sich in der Größenverteilung der Partikel, in der Beschichtung, in der Partikelform etc.

Die ferromagnetischen oder ferrimagnetischen Partikel 19 sind vorzugsweise Carbonyleisenpulver mit sphärischen Mikropartikeln, wobei die Größenverteilung und Form der Partikel vom konkreten Einsatzfall abhängt. Konkret bevorzugt ist eine Verteilung der Partikelgröße zwischen ein und zwanzig Mikrometern, wobei aber auch kleinere (< 1 Mikrometer) bis sehr kleine (wenige Nanometer, typischerweise 5 bis 10 Nanometer) oder größere Partikel von zwanzig, dreißig, vierzig und fünfzig Mikrometer möglich sind. Je nach Anwendungsfall kann die Partikelgröße auch deutlich größer werden und sogar in den Millimeterbereich vordringen (Partikelkugeln). Die Partikel können auch eine spezielle Beschichtung/Mantel (Titanbeschichtung, Keramik-, Karbonmantel, polymere Beschichtung etc.) aufweisen, damit sie die je nach Anwendungsfall auftretenden hohen Druckbelastungen besser aushalten bzw. stabilisiert sind. Die Partikel können auch eine Beschichtung gegen Korrosion oder elektrische Leitung haben. Die magnetorheologischen Partikel können für diesen Anwendungsfall nicht nur aus Carbonyleisenpulver (Reineisen; Eisenpentacarbonyl), sondern z. B. auch aus speziellem Eisen (härterem Stahl) oder anderen speziellen Materialien (Magnetit, Cobalt...), oder einer Kombination daraus, hergestellt werden. Superparamagnetische Partikel mit geringer Hysterese sind auch möglich und vorteilhaft.

Der Wälzkörper 11 wird durch die Relativbewegung 17 der beiden Bremskomponenten 2 und 3 vorzugsweise in Rotation um seine Drehachse 12 versetzt und läuft praktisch auf der Oberfläche der Bremskomponente 3 ab. Gleichzeitig läuft der Wälzkörper 11 auf der Oberfläche der anderen Bremskomponente 2, sodass dort eine Relativgeschwindigkeit 18 vorliegt.

Genau genommen hat der Wälzkörper 11 keinen direkten Kontakt zur Oberfläche der Bremskomponenten 2 und/oder 3 und wälzt sich deshalb nicht direkt darauf ab. Der freie Abstand 9 von dem Wälzkörper 11 zu einer der Oberflächen der Bremskomponenten 2 oder 3 beträgt z. B. 140 um. In einer konkreten Ausgestaltung mit Partikelgrößen zwischen 1 um und 10 um liegt der freie Abstand insbesondere zwischen 75 um und 300 um und besonders bevorzugt zwischen 100 um und 200 um.

Der freie Abstand 9 beträgt insbesondere wenigstens das Zehnfache des Durchmessers eines typischen mittleren Partikeldurchmessers. Vorzugsweise beträgt der freie Abstand 9 wenigstens das Zehnfache eines größten typischen Partikels. Durch den fehlenden direkten Kontakt ergibt sich eine sehr geringe(s) Grundreibung/-kraft/- moment beim relativen Bewegen der Bremskomponenten 2 und 3 zueinander.

Wird die magnetorheologische Bremseinrichtung 1 mit einem Magnetfeld beaufschlagt, bilden sich die Feldlinien abhängig vom Abstand zwischen den Wälzkörpern 11 und den Bremskomponenten 2, 3 aus. Der Wälzkörper 11 besteht aus einem ferromagnetischen Material und z. B. hier aus ST 37 (S235). Der Stahltyp ST 37 hat eine magnetische Permeabilität ur von etwa 2000 (im relevanten Bereich). Die Feldlinien (Magnetkreis) treten durch den Wälzkörper hindurch und konzentrieren sich in dem Wälzkörper. An der hier radialen Ein- und Austrittsfläche der Feldlinien an dem Wälzkörper herrscht eine hohe magnetische Flußdichte in dem Kanal bzw. Spalt 5. Das dort inhomogene und starke Feld führt zu einer lokalen und starken Vernetzung der magnetisch polarisierbaren Partikel 19 (magnetische Verkettung). Durch die Drehbewegung des Wälzkörpers 11 in Richtung auf den sich bildenden Keil in dem magnetorheologischen Fluid wird die Wirkung stark erhöht und das mögliche Brems- oder Kupplungsmoment wird extrem vergrößert, weit über den Betrag hinaus, der normalerweise in dem magnetorheologischen Fluid erzeugbar ist. Vorzugsweise bestehen Wälzkörper 11 und Bremskomponenten 2, 3 zumindest teilweise aus ferromagnetischem Material, weshalb die magnetische Flussdichte umso höher wird, je kleiner der Abstand zwischen Drehkörper 11 und Bremskomponenten 2, 3 ist. Dadurch bildet sich ein im Wesentlichen keilförmiger Bereich 16 im Medium aus, in welchem der Gradient des Magnetfelds zum spitzen Winkel 16a bei der Kontaktstelle bzw. dem Bereich des geringsten Abstands hin stark zunimmt.

Trotz Abstand zwischen Wälzkörper 11 und Bremskomponenten 2, 3 kann durch die Relativgeschwindigkeit der Oberflächen zueinander der Wälzkörper 11 in eine Drehbewegung versetzt werden. Die Drehbewegung ist ohne und auch mit einem wirkenden Magnetfeld 8 möglich.

Wenn die magnetorheologische Bremseinrichtung 1 einem Magnetfeld 8 einer hier in Figur 2 nicht dargestellten elektrischen Spule 26a (vgl. Z. B. Figur 3) ausgesetzt ist, verketten sich die einzelnen Partikeln 19 des magnetorheologischen Fluides 6 entlang der Feldlinien des Magnetfeldes 8. Zu beachten ist, dass die in Figur 2 eingezeichneten Vektoren den für die Beeinflussung des MRF relevanten Bereich der Feldlinien nur grob schematisch darstellen. Die Feldlinien treten im Wesentlichen normal auf die Oberflächen der ferromagnetischen Bauteile in den Kanal 5 ein und müssen vor allem im spitzwinkligen Bereich 16a nicht geradlinig verlaufen.

Gleichzeitig wird auf dem Umfang des Wälzkörpers 11 etwas Material von dem magnetorheologischen Fluid mit in Rotation versetzt, sodass sich ein spitzwinkliger Bereich 16a zwischen der Bremskomponente 3 und dem Wälzkörper 11 ausbildet. Auf der anderen Seite entsteht ein gleicher spitzwinkliger Bereich 10 zwischen dem Wälzkörper 11 und der Bremskomponente 2. Die spitzwinkligen Bereiche 10 können beispielsweise bei zylinderförmig ausgestalteten Wälzkörpern 11 eine Keilform 16 aufweisen. Durch die Keilform 16 bedingt wird die weitere Rotation des Wälzkörpers 11 behindert, sodass die Wirkung des Magnetfeldes auf das magnetorheologische Fluid verstärkt wird, da sich durch das wirkende Magnetfeld innerhalb des spitzwinkligen Bereiches 16a ein stärkerer Zusammenhalt des dortigen Mediums 6 ergibt. Dadurch wird die Wirkung des magnetorheologischen Fluids im angesammelten Haufen verstärkt (die Kettenbildung im Fluid und damit der Zusammenhalt bzw. die Viskosität), was die weitere Rotation bzw. Bewegung des Drehkörpers 11 erschwert.

Durch die Keilform 16 (Partikelanhäufung) können wesentlich größere Kräfte oder Momente übertragen werden als es mit einem vergleichbaren Aufbau möglich wäre, der nur die Scherbewegung ohne Keileffekt nützt.

Die direkt durch das angelegte Magnetfeld übertragbaren Kräfte stellen nur einen kleinen Teil der durch die Vorrichtung übertragbaren Kräfte dar. Durch das Magnetfeld lässt sich die Keilbildung und somit die mechanische Kraftverstärkung steuern. Die mechanische Verstärkung des magnetorheologischen Effekts kann soweit gehen, dass eine Kraftübertragung auch nach Abschalten eines angelegten Magnetfeldes möglich ist, wenn die Partikel verkeilt wurden.

Es hat sich herausgestellt, dass durch die Keilwirkung der spitzwinkligen Bereiche 16 eine erheblich größere Wirkung eines Magnetfeldes 8 einer bestimmten Stärke erzielt wird. Dabei kann die Wirkung um ein Vielfaches verstärkt werden. In einem konkreten Fall wurde eine etwa zehnmal so starke Beeinflussung der Relativgeschwindigkeit zweier Bremskomponenten 2 und 3 zueinander wie beim Stand der Technik bei MRF Kupplungen nach dem Scherprinzip beobachtet, bei dem zwischen zwei sich zueinander bewegenden Flächen ein magnetorheologisches Fluid angeordnet ist und den Scherkräften der sich zueinander bewegenden Flächen ausgesetzt ist. Die mögliche Verstärkung hier durch die Keilwirkung hängt von unterschiedlichen Faktoren ab. Gegebenenfalls kann sie durch eine größere Oberflächenrauhigkeit der Wälzkörper 11 noch verstärkt werden. Möglich ist es auch, dass auf der Außenoberfläche der Wälzkörper 11 nach außen ragende Vorsprünge vorgesehen sind, die zu einer noch stärkeren Keilbildung führen können.

Die Keilwirkung bzw. der Keileffekt verteilt sich flächig auf den Wälzkörper 11 und die Komponenten 2 oder 3.

Figur 3 zeigt einen Schnitt durch eine haptische Bedieneinrichtung 100 mit einer magnetorheologischen Bremseinrichtung 1, die über zwei Bremskomponenten 2 und 3 verfügt. Die erste Bremskomponente 2 und die zweite Bremskomponente 3 erstrecken sich im Wesentlichen in eine axiale Richtung 20.

Die erste Bremskomponente 2 ist hier im Inneren der zweiten Bremskomponente 3 angeordnet und ist als Statoreinheit 22 ausgebildet, die von der darum drehbaren Rotoreinheit 23 umgeben wird. Die Statoreinheit 22 weist einen Statorschaft oder Schaft 22b und einen Statorkörper 22a auf. Der Statorkörper 22a wird durch einen Tragkörper 50 formschlüssig und/oder kraftschlüssig gehalten. Der Tragkörper 50 kann beispielsweise an einer externen Konsole oder an einem Gerät befestigt werden. Der Tragkörper 50 wird regelmäßig drehfest befestigt. Hier ist die erste bzw. innere Bremskomponente 2 drehfest mit dem Tragkörper 50 verbunden. Dazu ist der Schaft 22b der Statoreinheit 22 verdrehsicher an dem Tragkörper 50 aufgenommen. Die zweite Bremskomponente 3 ist relativ zu der ersten Bremskomponente 2 kontinuierlich drehbar daran aufgenommen.

Die zweite bzw. äußere Bremskomponente 3 ist länglich ausgebildet und verfügt über den Bremskörper 3a. Die äußere Bremskomponente 3 bildet hier eine um die Statoreinheit 22 drehbare Rotoreinheit 23, bei der der magnetisch leitfähige Bremskörper 3a den magnetisch leitfähigen Rotorkörper 23b bildet. Das Bedienteil 101 ist hier mit dem Rotorkörper 23b gekoppelt oder wird dadurch gebildet, sodass eine Drehbewegung des Bedienteils 101 in eine Drehbewegung des Rotorkörpers 23b umgesetzt wird oder direkt bewirkt. An dem Bedienteil 101 kann ein Überzug 49 angeordnet sein, welcher bei der Bedienung dann tatsächlich berührt wird. Dazu kann auch beispielsweise ein größeres und gegebenenfalls sehr schmales Rad oder z. B. Mausrad aufgebracht sein.

Die zweite und äußere Bremskomponente 3 ist an der Lagereinrichtung 30 drehbar an dem Tragkörper 50 aufgenommen. Die Lagereinrichtung 30 umfasst hier eine erste Lagereinheit 112 und eine zweite Lagereinheit 118. Die innere Bremskomponente 2 ist drehfest und gegebenenfalls axial verschiebbar an dem Tragkörper 50 aufgenommen. An den Lagereinheiten 112, 118 der Lagereinrichtung 30 können Kräfte in eine globale radiale Richtung 122 durch die Lagereinrichtung 30 abgestützt werden, während die erste Bremskomponente 2 relativ axial zur zweiten Bremskomponente 3 verschiebbar ist.

Zwischen den Bremskomponenten 2 und 3 ist eine geschlossene Kammer bzw. Bremskammer 110 ausgebildet, die mit MRF gefüllt ist und die über eine Dichtung 10 nach außen abgedichtet ist. Die Dichtung 10 dichtet das Innere zuverlässig ab und weist eine Dichtungsbasis 10a und eine Dichtungslippe 10b auf. Die Dichtungsbasis 10a liegt radial innen parallel an dem Statorschaft 22b an. Die Dichtungslippe 10b liegt radial außen an dem Innenumfang des Bremskörpers 3a der äußeren Bremskomponente 3 an. Die Bremskomponente 3 weist an dem Rotorkörper einen zylindrischen Innendurchmesser auf, der die Bremskammer 110 radial nach außen begrenzt. Die Dichtungslippe 10b stößt schräg von innen an die zylindrische Innenwandung an. Die Dichtung 10 weist hier einen etwa U- oder V-förmigen Querschnitt auf. Das "U" oder "V" ist dabei zu dem Innenraum der Bremskammer 110 hin geöffnet. Dadurch wird eine Verstärkung der Dichtwirkung von innen aus erzielt.

Diese Konstruktion ist sehr vorteilhaft. In dem Kontaktabschnitt 2b der Statoreinheit 22 mit der Dichtungsbasis 10a treten keine hohen Beanspruchungen auf. Deshalb kann ein kostengünstiges Material wie z. B. ein Kunststoff für den Statorschaft 22b gewählt werden. Die Statoreinheit kann so z. B. einteilig oder insbesondere mehrteilig im Spritzgussverfahren hergestellt werden. Der Statorschaft muss keine besondere Härte aufweisen, um einen Verschleiß zu verhindern, da keine reibende abrasive Kontaktbewegung der Dichtung 10 an dem Statorschaft 22b auftritt. Es ist nicht nötig, eine Hülse aus einem widerstandsfähigeren Werkstoff wie z. B. Metall an dem Statorschaft aufzubringen. Da an dem Statorschaft keine gleitende Relativbewegung einer Dichtungslippe auftritt, muss auch kein Schutz vor der mechanischen Einwirkung einer Dichtungslippe an der inneren Bremskomponente 2 vorgesehen sein.

Die äußere Bremskomponente 3 hingegen bzw. der Bremskörper 3a der äußeren Bremskomponente 3 ist magnetisch leitfähig ausgebildet. Das Magnetfeld 8 der Magnetfeldquelle 26 wird durch den magnetisch leitfähigen Bremskörper 3a geleitet und ist deshalb aus einem gegen Abrasion erheblich widerstandsfähigeren Material als der Schaft der inneren Bremskomponente 2. Gegebenenfalls kann der magnetisch leitfähige Bremskörper 3a auch innen im Kontaktbereich 3b mit der Dichtungslippe 10b (oder auch vollständig) eine zusätzliche Härtung oder Härtungsbeschichtung aufweisen. Regelmäßig reicht aber die Materialeigenschaft des magnetisch leitfähigen Materials des Bremskörpers 3a aus, wie z. B. Stahl aus, um eine ausreichende Standfestigkeit gewährleisten zu können. Obwohl ein niedriges Grundmoment zur Drehung des Bedienteils 101 bei den Anwendungen wesentlich ist, hat sich herausgestellt, das der reibtechnisch an sich ungünstigere Aufbau mit der Dichtungslippe 10b radial nach außen insgesamt zu besseren Ergebnissen führt als ein umgekehrter Aufbau. Und das obwohl das Reibmoment an sich durch den größeren Umfang der Reibfläche und aufgrund des größeren Durchmessers größer ist. Das liegt an dem vereinfachten Aufbau und auch der Reduzierung der Teileanzahl und dem verringerten Bauraum. Insgesamt wird ein äußerst kompakter Aufbau ermöglicht, der nur ein minimales Grundmoment und ein sehr hohes maximales Bremsmoment aufweist. Durch den besonders kompakten Aufbau können die Abmessungen nochmals reduziert werden, wodurch auch das Grundmoment noch einmal reduziert werden kann. Das war ein unerwartetes Ergebnis.

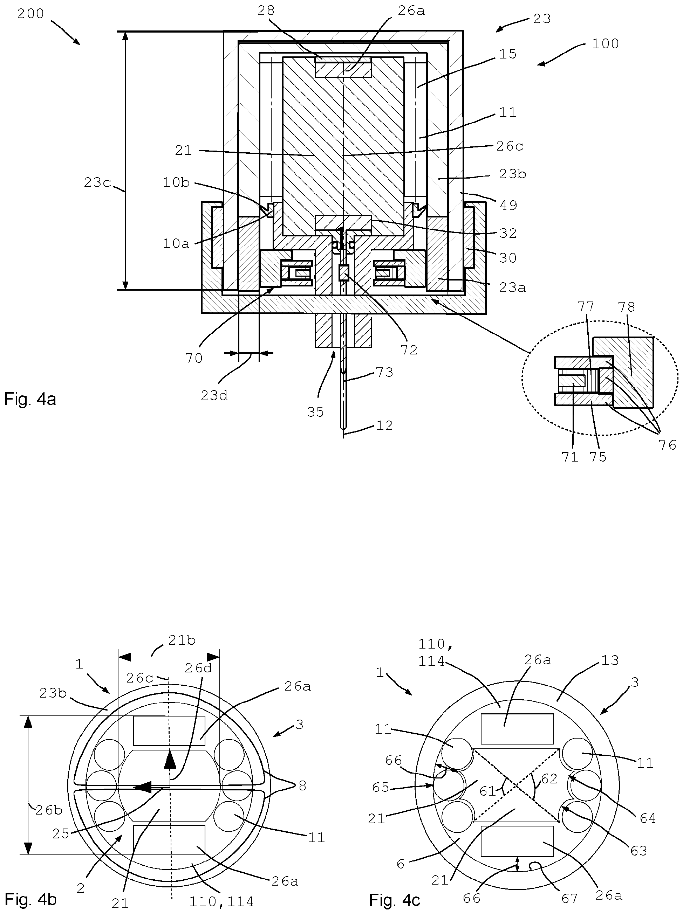

Die erste Bremskomponente 2 weist einen Statorkörper 22a und einen daran aufgenommenen Kern 21 auf. Um den Kern 21 sind die Wicklungen einer elektrischen Spule 26a gewickelt. Dabei können die einzelnen Windungen der elektrischen Spule 26a nach außen über den zylindrischen Statorkörper 22a hervorstehen, wie es in Fig. 4b gezeigt ist. Möglich ist es aber auch, dass die Windungen der elektrischen Spule 26a nicht überstehen.

Radial besteht zwischen der Außenwandung der ersten Bremskomponente 2 und der inneren Wandung des äußeren Bremskörpers 3a ein Spalt 5, der hier im Wesentlichen als hohlzylindrischer Spalt ausgeführt ist. In dem Spalt sind mehrere Übertragungskomponenten 11, die hier als Wälzkörper ausgebildet sind, angeordnet. Die Wälzkörper 11 sind hier als zylindrische Wälzkörper ausgebildet und weisen einen Außendurchmesser auf, der etwas geringer ist als die Spaltenbreite des Spaltes 5. Der Spalt 5 ist des Weiteren hier mit einem magnetorheologischen Medium gefüllt.

Im einem Bereich des Spaltes kann beispielsweise ein mit Luft oder einem anderen Gas gefüllter O-Ring oder dergleichen angeordnet sein, der einen Volumenausgleich bei Temperaturschwankungen zur Verfügung stellt. Außerdem wird dadurch dort ein Reservoir gebildet, falls im Laufe des Betriebes magnetorheologisches Fluid bzw. Medium aus dem Inneren nach außen austritt. Hier kann der Statorkörper axial verfahren, um einen automatischen Temperaturausgleich und ein Reservoir für MRF zur Verfügung zu stellen.

Die (nutzbare) Spaltlänge des Spaltes 5 ist hier größer als die Länge der Wälzkörper 11. Hier ist auch die elektrische Spule 26a in der axialen Richtung 20 länger ausgebildet als die Länge der Wälzkörper 11.

Im Inneren der elektrischen Spule 26a ist der Kern 21 zu erkennen. Der Statorkörper 22a weist eine radial vergrößerte Aufnahme auf. Durch den Schaft 22b erstreckt sich eine Kabeldurchführung 35 nach unten durch den Schaft 22b hindurch. Dort werden Kabel 45 zum Anschluss der elektrischen Spule 26a und gegebenenfalls Sensorleitungen herausgeführt. Eine Steuereinrichtung 27 kann im Fuß des Schafts 22b oder an anderen geeigneten Stellen - auch extern - vorgesehen oder zugeordnet sein, um eine bedarfsgerechte Steuerung vorzunehmen.

Die Bremskammer 110 ist nach außen geschlossen ausgebildet. Die geschlossene Kammer 110 umfasst das Volumen 114, welches im Wesentlichen vollständig mit dem magnetorheologischen Medium 6 gefüllt ist.

Eine Änderung des Volumens der magnetorheologischen Mediums 6 führt hier zu einer relativen axialen Verschiebung der ersten Bremskomponente 2 zur zweiten Bremskomponente 3.

Für den Fall, dass die erste Bremskomponente 2 feststeht, wird die zweite Bremskomponente 3 im Falle einer Volumenzunahme in der Orientierung von Figur 3 nach rechts verschoben. Dadurch wird das Volumen 114 der geschlossenen Kammer 110 vergrößert. So kann insbesondere eine durch einen Temperaturanstieg bedingte Volumenänderung des magnetorheologischen Mediums 6 ausgeglichen werden. Eine Funktion der Magnetfeldquelle 26 wird hierdurch nicht beeinflusst. Im Falle einer Volumenabnahme, welche temperaturbedingt oder auch durch eine Leckage zustande kommen kann, wird die zweite Bremskomponente 3 hier nach links verschoben.

Bei der Verschiebung herrscht innerhalb der magnetorheologischen Bremskomponente 1 praktisch immer Umgebungsdruck. Vor allem wird so eine zusätzliche Belastung der Dichtung 10 verhindert. Bei einer Ausgleichseinrichtung über eine Gasblase wird der Innenraum hingegen immer unter Überdruck gesetzt, wodurch eine höhere Leckage und eine höhere Reibung durch die erforderliche bessere Dichtung entstehen.

Figur 4a zeigt eine andere haptische Bedieneinrichtung 100 im Schnitt mit einer ähnlichen magnetorheologischen Bremseinrichtung 1. Es sind die Quernuten 32 erkennbar, in denen die elektrische Spule 26a an den axialen Enden des Kerns 21 gewickelt ist. In axialer Richtung ist zum Abschluss an beiden Enden jeweils Vergussmasse 28 vorgesehen. Im Bereich der Kabeldurchführung 35 ist eine separate Dichtung über beispielsweise den eingezeichneten O-Ring oder dergleichen vorgesehen. Dort findet am O-Ring keine Relativbewegung statt.

Es ist auch möglich, dass einzelne der über einem Teil des Umfangs verteilt angeordneten Wälzkörper als magnetisch nicht leitfähige Übertragungskomponenten ausgebildet sind. Vorzugsweise sind alle Wälzkörper aus magnetisch leitendem Material wie z. B. Stahl.

Eine Länge bzw. Höhe 23c des Bedienteils 101 oder des Rotorkörpers 23 der zweiten Bremskomponente 3 in axialer Richtung 20 beträgt vorzugsweise zwischen 5 mm und 90 mm. Es ist möglich und in Fig. 4a eingezeichnet, dass an dem Ende des Bremskörpers 3a mit dem Statorschaft 22b eine separate Hülse 23a angebracht ist, die den Bremskörper 3a verlängert. Eine solche Hülse 23a muss nicht aus einem magnetisch leitfähigen Material bestehen und besteht hier vorzugsweise nicht daraus. Eine solche Hülse 23a vergrößert den axialen Abstand der elektrischen Spule 26a und des magnetisch leitfähigen Bremskörpers 3a von der Sensoreinrichtung 70, sodass eine magnetisch noch bessere Entkopplung der Messergebnisse erzielt wird.

Die Sensoreinrichtung 70 dient zur Detektion einer Winkelstellung der beiden Bremskomponenten 2, 3 relativ zueinander, vgl. das vergrößerte Detail in Fig. 4a unten rechts. Die Detektion erfolgt mit einer Magnetringeinheit 71 und mittels eines Magnetfeldsensors 72. Die Sensoreinrichtung 70 ist hier über eine Entkopplungseinrichtung 78 an der zweiten Bremskomponente 3 angeschlossen. Die Entkopplungseinrichtung 78 entkoppelt die Sensoreinrichtung magnetisch. Die Sensoreinrichtung 70 umfasst hier weiter eine Abschirmeinrichtung 75, die hier mehrere Abschirmkörper 76 umfasst und die die Magnetringeinheit 71 auf drei Seiten umgibt. Zwischen der Magnetringeinheit und der Abschirmeinrichtung 75 ist eine Trenneinheit 77 vorhanden. Die Trenneinheit 77 schirmt die Magnetringeinheit 71 zusätzlich ab. Dadurch wird das von der Magnetringeinheit 71 aufgespannte Volumen weitgehend von magnetischen Einflüssen der elektrischen Spule 26a oder anderen Magnetfeldern abgeschirmt.

Auf der zweiten Bremskomponente 3 kann außen ein Überzug 49 angebracht sein, sodass das äußere Erscheinungsbild des Drehknopfes 23 im Wesentlichen durch die Oberfläche des Überzugs 49 bestimmt wird.

Das Material des Bremskörpers 3a bzw. des Rotorkörpers 23b ist magnetisch leitend und dient zur Schließung des Magnetkreises. Eine Wandstärke 23d des Rotorkörpers 23b ist vorzugsweise wenigstens halb so groß wie ein Durchmesser der Wälzkörper 11.

Es ist bevorzugt, den Kern 21 und auch den Statorschaft 22b zweiteilig auszuführen. Bevorzugt verläuft die Trennung entlang der in Figur 4a gezeichneten Mittellinie, wodurch sich eine linke und rechte (Kern)hälfte ergibt. Die zwei Kernhälften können durch ein magnetisch nicht leitendes Element (z. B. Dichtung) voneinander beabstandet sein. Vorzugsweise ist das Vergussmassenvolumen 28 dann ein Teil der Kernhälfte(n), wodurch sich ein Halbkreiselement mit einer umlaufenden Nut auf der Trennfläche für die Elektrospule ergibt. Weiters bevorzugt wird der Statorkörper 22a auch in zwei Hälften getrennt. Eine Hälfte des Statorkörpers 22a kann auch mit einer Kernhälfte einen Teil bilden (einteilig ausgeführt werden) oder eine Kernhälfte mit einer kompletten Aufnahmeeinheit einteilig ausgeführt werden.

Hier ist die haptische Bedieneinrichtung 100 mit der magnetorheologischen Bremseinrichtung 1 einseitig gelagert. Die zweite Bremskomponente 3 ist hier nur an dem ersten Ende der geschlossenen Bremskammer 110 gelagert. Die Lagerung erfolgt auf der Außenseite der äußeren Bremskomponente 3 mit einer Lagereinrichtung 30.

Bei einer Änderung des Volumens innerhalb der geschlossenen Bremskammer kann sich die erste Bremskomponente 2 leicht hin und her bewegen. Hierbei ist wieder angenommen, dass sich die erste Bremskomponente 2 nicht dreht und axial verschiebbar aufgenommen ist. Vorteilhaft ist das System innerhalb des gegebenen Bewegungsspielraums praktisch immer bei Umgebungsdruck. Eine zusätzliche Belastung der Dichtung 10 wird verhindert.

Figuren 4b und 4c zeigen verschiedene schematische Querschnitte der magnetorheologischen Bremseinrichtung 1, die bei der Ausgestaltung nach Figur 4a und auch in anderen Ausführungsbeispielen einsetzbar sind.

Die innere Bremskomponente 2 ist feststehend ausgebildet und wird von der kontinuierlich drehbaren Bremskomponente 3 umgeben. Die zweite Bremskomponente 3 weist einen sich um die erste Bremskomponente herum drehbaren und hohl und innen zylindrisch ausgebildeten magnetisch leitenden Bremskörper 3a auf. Deutlich erkennbar ist der zwischen der ersten und der zweiten Bremskomponente 2, 3 umlaufende Spalt 5. Der Spalt 5 ist hier wenigstens zum Teil und insbesondere vollständig mit einem magnetorheologischen Medium 6 gefüllt.

Die erste Bremskomponente 2 weist den sich in der axialen Richtung 20 erstreckenden Kern 21 aus einem magnetisch leitfähigen Material und eine elektrische Spule 26a auf, die in axialer Richtung 20 um den Kern 21 gewickelt ist und eine Spulenebene 26c aufspannt. Das Magnetfeld 8 der elektrischen Spule 26 erstreckt sich quer zu der axialen Richtung 20 durch die erste Bremskomponente 2 bzw. den Kern 21.

Es ist klar erkennbar, dass ein maximaler äußerer Durchmesser 26b der elektrischen Spule 26a in einer radialen Richtung 26d innerhalb der Spulenebene 26c größer ist als ein minimaler äußerer Durchmesser 21b des Kerns 21 in einer radialen Richtung 25 quer und z. B. senkrecht zu der Spulenebene 26c.

Die Wälzkörper 11 sind jeweils nur in Winkelsegmenten 61, 62 angeordnet und können nicht vollständig um den Kern 21 rotieren, da die elektrische Spule 26a in den Spalt 5 bzw. Kanal hineinragt und damit einen vollständigen Umlauf verhindert.

Dadurch steht weniger Platz für die Wälzkörper 11 zur Verfügung.

Das führt aber zu einer noch höheren Konzentration des Magnetfeldes 8. In Figur 4b sind beispielhaft drei Magnetfeldlinien eingezeichnet.

In Figur 4c sind die Wälzkörper 11 nicht an einer zylindrischen Außenoberfläche des Kerns 21 aufgenommen, sondern an speziell an die Kontur der Wälzkörper 11 angepasste Aufnahmen 63, an denen die Wälzkörper 11 vorzugsweise mit etwas Spiel aufgenommen und geführt sind. Der Übergang des Magnetfeldes 8 in die Wälzkörper 11 hinein ist vorteilhaft, da mehr Übertragungsfläche zwischen dem Kern 21 bzw. der Außenoberfläche 64 an den Aufnahmen 63 und den Wälzkörpern 11 zur Verfügung steht.

Dabei liegt der Querschnitt nach Fig. 4c vorzugsweise nur in axialen Endbereichen vor, sodass die z. B. zylindrischen Wälzkörper 11 an den Enden durch die Aufnahmen 63 geführt und in Umfangsrichtung definiert gehalten werden. Über den mittleren Abschnitt ist der Kern dann ausgebildet, wie in Fig. 4b.

Die elektrische Spule 26a ist jedenfalls außerhalb der Winkelsegmente 61 und 62 angeordnet. Außerhalb der Winkelsegmente 61 und 62 befinden sich hier keine Wälzkörper 11.

Möglich sind auch Konstruktionen, bei denen auf Wälzkörper 11 vollständig verzichtet wird. Die Kerne 21 weisen dann nach außen abstehende Übertragungskomponenten 11 auf, die sich von dem Grundkörper 33 aus radial nach außen erstrecken. Der maximale äußere Durchmesser 26a der Spule 26 ist dabei größer als der minimale Kerndurchmesser 21b. Die radiale Erstreckung des Spaltes 5 variiert über dem Umfang. An den äußeren Enden der Übertragungskomponenten 11 liegt nur ein geringes Spaltmaß 65 vor, während ein radialer Abstand 66 zwischen der Bremskomponente 2 und der Bremskomponente 3 an anderen Stellen erheblich größer ist.

In allen Ausführungsbeispielen wird vorzugsweise eine "liegende oder axiale Spule" verwendet, bei der die elektrische Spule 26a in axialer Richtung 20 um den Kern 21 gewickelt ist und wieder einen maximalen radialen Spulendurchmesser 26b aufweist, der größer ist als ein minimaler Kerndurchmesser 21b des Kerns 21. Dann sind die Wälzkörper 11 oder Übertragungselemente nicht über dem vollständigen Umfang angeordnet.

Vorzugsweise ist in jeder Ausgestaltung eine Sensoreinrichtung 70 zur Detektion einer Winkelstellung der haptischen Bedieneinrichtung 100 vorhanden. Der Magnetfeldsensor 72 ist vorzugsweise in oder an dem Schaft 22b bzw. der ersten Bremskomponente 2 integriert.

Die Statoreinheit 22 ist insbesondere zweiteilig ausgeführt. Dadurch wird vor allem die Montage der elektrischen Leitungen und insbesondere der Sensorleitung 73 innerhalb der ersten Bremskomponente 2 vereinfacht. Die Kabel können durch die offene Kabeldurchführung 35 gelegt werden.

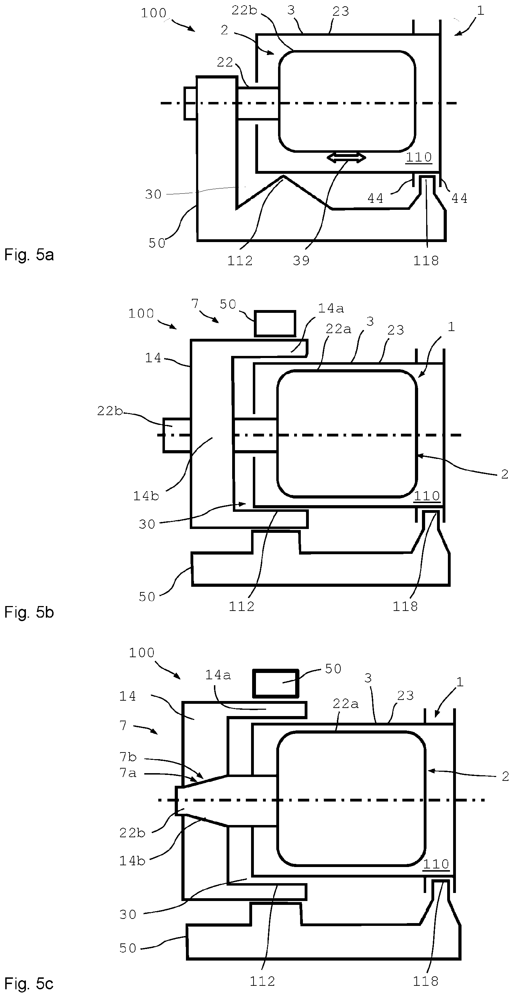

Die Figur 5a zeigt eine haptische Bedieneinrichtung 100, welche an verschiedenen Gerätekomponenten 200 und u.a. auch in einer Computermaus 103 eingesetzt werden kann. Die haptische Bedieneinrichtung 100 umfasst ein drehbares Bedienteil 101 mit einer Rotoreinheit 23. Die Bedienung erfolgt durch ein Drehen der Rotoreinheit 23.

Die Rotoreinheit 23 ist um eine Statoreinheit 22 drehbar gelagert. Die Statoreinheit 22 umfasst hier einen Statorkörper 22a und einen Statorschaft 22b. Die Drehachse der Rotoreinheit 23 ist hier strichpunktiert dargestellt. Die Drehachse entspricht hier zugleich auch einer axialen Mittelachse der Statoreinheit 22 und der Rotoreinheit 23.

Die Statoreinheit 22 ist an einem Tragkörper 50 befestigt. Der Tragkörper 50 kann beispielsweise ein Mauskörper 103a der Computermaus 103 der Fig. 1c sein. An dem Mauskörper 103a können verschiedene Maustasten 103b und 103c z. B. links und rechts des Mausrads 106 ausgebildet sein.

Die Drehbewegung bzw. Drehbarkeit der Rotoreinheit 23 um die Statoreinheit 22 ist hier mittels einer magnetorheologisch ausgebildeten Bremseinrichtung 1 gezielt verzögerbar. Die Bremseinrichtung 1 erzeugt mit einer hier nicht näher dargestellten Magnetfeldquelle 26 und beispielsweise einer elektrischen Spule 26a ein Magnetfeld, das auf ein magnetorheologisches Medium (MR-Flüssigkeit) als Bremsmedium einwirkt. Das führt zu einer lokalen und starken Vernetzung von magnetisch polarisierbaren Partikeln und zu einer Erhöhung der übertragbaren Schubspannung im Bremsmedium.

Die Bremseinrichtung 1 ermöglicht dadurch eine gezielte Verzögerung (Bremsen) und sogar ein vollständiges Blockieren (hohes Bremsmoment) der Drehbewegung. So kann mit der Bremseinrichtung 1 eine haptische Rückkopplung (haptisches Feedback) während der Drehbewegung der Rotoreinheit 23 erfolgen, beispielsweise durch eine entsprechend wahrnehmbare Rasterung (Rippel) bzw. durch dynamisch einstellbare Anschläge. Um die Drehposition der Rotoreinheit 23 zu überwachen und zur Ansteuerung der Bremseinrichtung 1 einsetzen zu können, ist eine hier nicht näher gezeigte Sensoreinrichtung 70 (vgl. Fig. 4a) vorgesehen.

Das Bremsmedium ist in einer nach außen abgedichteten Bremskammer 110 aufgenommen. Die Bremskammer 110 wird hier von der Rotoreinheit 23 und der Statoreinheit 22 begrenzt.

Die Rotoreinheit 23 ist hier (nur) an dem Tragkörper 50 gehalten (zur Ableitung des durch die Bremsung erzeugten Reaktionsdrehmomentes). Dadurch können die axialen Abmessungen der Bedieneinrichtung 100 erheblich verringert werden, was beispielsweise für den Einbau in eine Computermaus 103 oder ein Lenkrad eines Fahrzeuges von großem Vorteil ist. Zudem ist hier eine von der Statoreinheit 22 unabhängige Lagerung der Rotoreinheit 23 vorgesehen. So können die Lagerkräfte und Druckbelastungen beim Drehen mit einem Finger unter Umgehung der Statoreinheit 22 direkt in den Tragkörper 50 abgeleitet werden. Die Statoreinheit sieht nur das Reaktionsdrehmoment und keine Lager- oder Radialkräfte, wodurch der Statorschaft 22b dünner und damit platzsparender dimensioniert werden kann. Insgesamt ergibt sich eine besonders kompakte und robuste sowie zugleich haptisch präzise Bedienung.

Zur Lagerung der Rotoreinheit 23 ist hier eine Lagereinrichtung 30 mit einer Lagereinheit 112 und einer weiteren Lagereinheit 118 vorgesehen. Über die Lagereinheiten 112, 118 ist die Rotoreinheit 23 nach radial außen an den Tragkörper 50 gelagert bzw. abgestützt. Dazu sind die Lagereinheiten 112, 118 hier an der radialen Außenseite der Rotoreinheit 23 angeordnet.

Im Bereich der weiteren Lagereinheit 118 sind an der Rotoreinheit 23 hier Wegbegrenzungen 44 angeordnet. Dadurch wird eine axiale Verschiebung der Rotoreinheit 23 um einen definierten Weg ermöglicht. Die Wegbegrenzungen 44 können auch derart angeordnet sein, dass die axiale Bewegbarkeit blockiert wird.

Wenn eine axiale Bewegbarkeit der Rotoreinheit 23 relativ zum Tragkörper 50 unerwünscht ist, können eine oder beide Lagereinheiten 112, 118 auch als Festlager ausgebildet sein. Hier kann beispielsweise die weitere Lagereinheit 118 als Festlager ausgebildet sein.

Um temperaturbedingte oder leckagebedingte Volumenänderungen des Bremsmediums in der Bremskammer 110 zu ermöglichen bzw. zu kompensieren, kann das Volumen der Bremskammer 110 angepasst werden. Dazu sind die Rotoreinheit 23 und die Statoreinheit 22 hier relativ zueinander axial verschiebbar ausgebildet. Die Bewegung für einen solchen Volumenausgleich 39 ist hier durch einen Doppelpfeil skizziert.

Bei einem Volumenausgleich 39 wird der Statorschaft 22 hier aus der Bremskammer 110 herausgeschoben bzw. in die Kammer hineingeschoben. Dazu ist der Statorschaft 22b hier axial verschiebbar an dem Tragkörper 50 aufgenommen. Damit bei einer Verzögerung der Drehbewegung das Verzögerungsmoment in den Tragkörper 50 abgeleitet werden kann, ist der Statorschaft 22b aber auch drehfest an den Tragkörper 50 angebunden.

Die Figur 5b zeigt eine Weiterbildung der zuvor vorgestellten haptischen Bedieneinrichtung 100 aus Fig. 5a. Dabei ist hier die Statoreinheit 22 mit einem Schafthalter 14 an dem Tragkörper 50 befestigt. Der Schafthalter 14 ist axial verschiebbar an dem Tragkörper 50 angeordnet. Die Statoreinheit 22 ist hingegen drehfest und axial unbewegbar an dem Schafthalter 14 befestigt.

Dadurch verschiebt sich die Statoreinheit 22 bei einem Volumenausgleich gemeinsam mit dem Schafthalter 14 relativ zum Tragkörper 50. Aufgrund des Schafthalters 14 und seines entsprechend großen Radius kann die axiale Bewegung hier über einen größeren Bereich (große Flächen; große Abstände) abgestützt werden, sodass sich insgesamt eine verbesserte axiale Führung und Ausrichtung ergeben.

Der Schafthalter 14 umgibt hier mit einem Abschnitt 14a abschnittsweise die Außenseite der Rotoreinheit 23. Die Lagereinheit 112 ist an dem Schafthalter 14 angeordnet, sodass die Rotoreinheit 23 über den Schafthalter 14 an dem Tragkörper 50 gelagert ist. Auch dadurch werden Lagerung und axiale Verschiebbarkeit sowie Ausrichtung der Komponenten verbessert.

Die haptische Bedieneinrichtung 100 umfasst hier eine Ausrichtungseinrichtung 7 zum Ausrichten der axialen Mittelachse der Statoreinheit 22 relativ zu der axialen Mittelachse bzw. der Drehachse der Rotoreinheit 23. Für die Ausrichtungseinrichtung 7 ist der Schafthalter 14 hier achsensymmetrisch ausgebildet. Dadurch weisen der Abschnitt 14a des Schafthalters 14, welcher die Rotoreinheit 23 radial umgibt und an dem auch die Lagereinheit 112 angeordnet ist, und ein Abschnitt 14b des Schafthalters 14 eine gemeinsame axiale Mittelachse auf. Der Abschnitt 14b dient hier zur Befestigung des Statorschafts 22b.

Dadurch ermöglicht der Schafthalter 14 hier eine präzise konzentrische Ausrichtung von Rotoreinheit 23 und Statoreinheit 22 und wird zugleich auch zum Tragkörper 50 ausgerichtet. Beispielsweise kann eine solche Ausrichtungseinrichtung 7 dadurch bereitgestellt werden, dass der Schafthalter 14 als ein Drehteil mit einer größeren zentrischen Bohrung für den Abschnitt 14a und einer kleineren zentrischen Bohrung für den Abschnitt 14b ausgebildet ist.

Die Figur 5c zeigt die mit Bezug zu der Figur 5b vorgestellte Bedieneinrichtung 100 mit einer erweiterten Ausrichtungseinrichtung 7, mit der eine noch präzisere Ausrichtung des Statorschaftes 22b an dem bzw. in dem Schafthalter 14 erreicht wird. Der Statorschaft 22b umfasst dazu einen konischen Ausrichtungsabschnitt 7a. Der Ausrichtungsabschnitt 7a ist in einem korrespondierenden konischen Ausrichtungsteil 7b des Schafthalters 14 und beispielsweise einer konischen Ausnehmung angeordnet. Dadurch wird die Statoreinheit 22 beim Zusammenfügen mit dem Schafthalter 14 optimal (spielfrei, konzentrisch) ausgerichtet.

Der Statorschaft 22b kann auch durch eine konische Spannzange im Schafthalter 14 ausgerichtet werden. Zusätzlich oder alternativ kann der Statorschaft 22b im Schafthalter 14 verschraubt oder anderweitig kraftschlüssig bzw. formschlüssig fixiert werden. Möglich ist auch eine stoffschlüssige Fixierung, z. B. durch (Ultraschall-) Schweißen oder Verkleben.

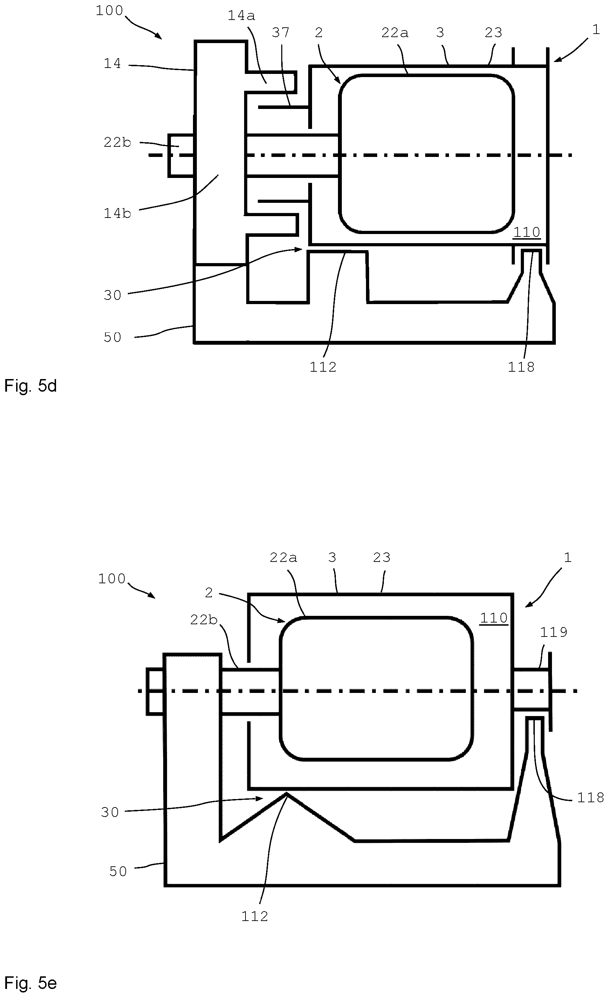

In der Figur 5d ist die mit Bezug zu der Figur 5c vorgestellte Bedieneinrichtung 100 mit einer alternativen Anordnung von Schafthalter 14 und Rotoreinheit 23 gezeigt. Dabei umgreift der Schafthalter mit seinem Abschnitt 14b hier eine als Fortsatz 37 ausgebildete radiale Außenseite der Rotoreinheit 23. Eine solche Ausgestaltung bietet neben den zuvor diskutierten Vorteilen besonders geringe radiale Abmessungen.

Hier sind beide Lagereinheiten 112, 118 direkt am Tragkörper 50 angeordnet. Alternativ oder zusätzlich kann aber auch eine Lagerung an dem Fortsatz 37 vorgesehen sein.

In der Figur 5e ist die mit Bezug zu der Figur 5a vorgestellte Bedieneinrichtung 100 mit einer alternativen Lageranordnung gezeigt. Dabei weist die Rotoreinheit 23 hier an einem axialen Ende einen Fortsatz in Form eines Achsstummels 119 auf, an welchem die Lagereinheit 118 angeordnet ist. Je nach vorhandenem Bauraum hat diese Ausgestaltung Vorteile.

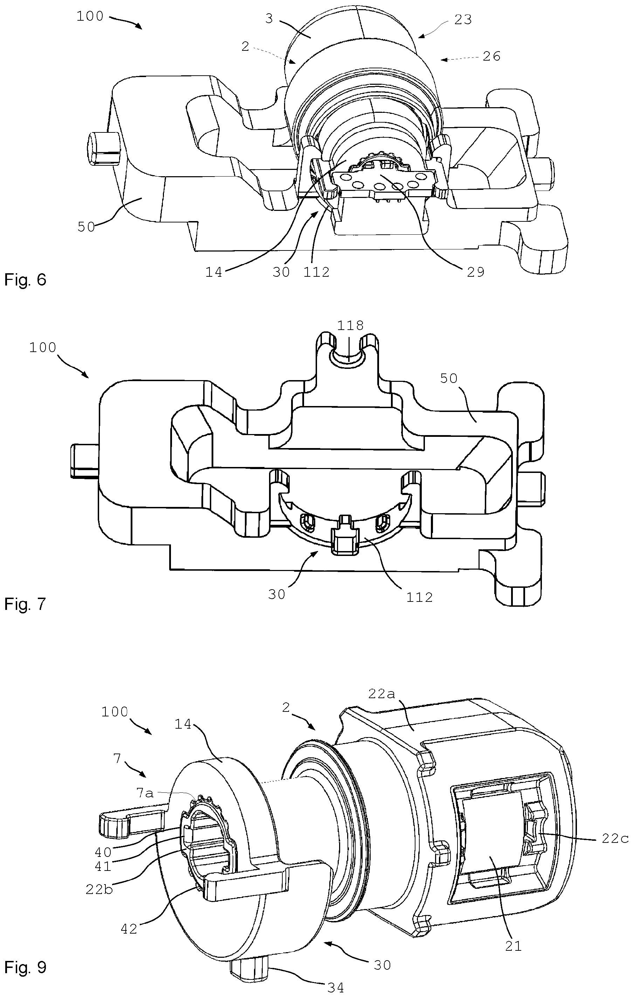

Mit Bezug zu den Figuren 6 bis 12 wird nun eine weitere beispielhafte Ausführung der haptischen Bedieneinrichtung 100 beschrieben, wie sie besonders vorteilhaft in verschiedenen Gerätekomponenten 200 eingesetzt werden kann. Beispielsweise ist der Einsatz an einer Computermaus 103 oder einer Daumenwalze 102 möglich.

Der Tragkörper 50 ist hier so ausgestaltet, dass genügend Raum zur Verfügung steht, um die Rotoreinheit 23 mit einem umlaufenden Ring oder dergleichen für z. B. ein Mausrad 106 ausstatten zu können.

In der Figur 6 ist die haptische Bedieneinrichtung 100 perspektivisch dargestellt. Die Statoreinheit 22 ist hier im Wesentlichen nicht sichtbar von anderen Komponenten verdeckt. Von der Bremseinrichtung 1 ist hier nur eine Elektronikeinheit (PCB und Stecker) 29 sichtbar. An dem Tragkörper 50 ist hier der Schafthalter 14 befestigt bzw. verclipst. In der hier gezeigten Darstellung ist von der Lagereinrichtung 30 nur die Lagereinheit 112 erkennbar. Die weitere Lagereinheit 118 ist hier nicht sichtbar hinter der Rotoreinheit 23 angeordnet.

Die Figur 7 zeigt den Tragkörper 50 der Bedieneinrichtung 100 der Figur 6. Der Tragkörper 50 ist hier als einstückiges Formteil beispielsweise aus Kunststoff ausgeführt. Die Lagereinheiten 112, 118 bzw. deren Aufnahmebereiche sind hier gut zu erkennen. An solchen Aufnahmebereichen können z. B. ein oder mehrere Gleitlager oder Wälzlager anordenbar sein. Die Aufnahmebereiche können die jeweilige Lagereinheit 112, 118 auch wenigstens teilweise selbst bereitstellen.

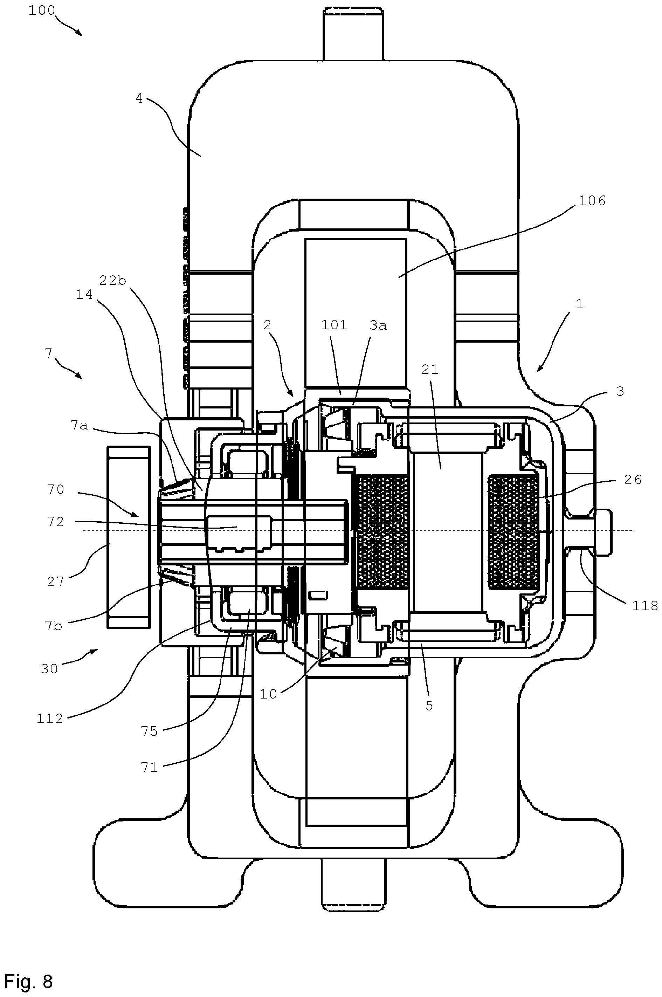

Die Figur 8 zeigt eine teilweise geschnittene Draufsicht der haptischen Bedieneinrichtung 100 der Figur 6. Zur Bereitstellung des Mausrads 106 ist die Rotoreinheit 23 hier mit einem grob skizzierten umlaufenden Ring ausgestattet. In dem geschnitten dargestellten Bereich sind hier der konische Ausrichtungsabschnitt 7 des Statorschaftes 22b und das zugehörige Ausrichtungsteil 7b im Schafthalter 14 gut zu erkennen.

Die Dichtung 10 zur Abdichtung der Bremskammer 110 weist einen etwa V-förmige Querschnitt auf und liegt mit einem Schenkel des "V", nämlich der Dichtungsbasis 10a, an dem Statorkörper an. Der andere Schenkel liegt radial außen an dem Innenumfang des magnetisch leitfähigen Bremskörpers 3b der äußeren Bremskomponente 3 an und dichtet über die Dichtungslippe 10b die Bremskammer 110 nach außen ab. Dadurch kann eine sehr kompakte Bremskammer 110 und Bremseinrichtung 1 zur Verfügung gestellt werden. Die Bremseinrichtung 1 benötigt ein nur äußerst geringes Bauvolumen. Auch die benötigte Menge des magnetorheologischen Mediums ist besonders gering, was die Kosten verringert.

Über den magnetorheologischen Bremskörper 3a wird das Magnetfeld der Magnetfeldquelle 26 geschlossen, welches im Wesentlichen von der elektrischen Spule 26a erzeugt wird und den radial umlaufenden Spalt 5 zwischen der inneren Bremskomponente 2 und der äußeren Bremskomponente 3 durchtritt.

Ein erheblicher Vorteil des dargestellten inneren Aufbaus ist, dass die Sensoreinrichtung 70 in axialer und radialer Richtung weit von der elektrischen Spule 26a und den anderen Komponenten des Magnetkreises und insbesondere auch von dem äußeren Bremskörper 3a der äußeren Bremskomponente 3 entfernt angeordnet ist. Dadurch wird die Intensität wechselnder Streufelder in dem Bereich der Sensoreinrichtung 70 erheblich reduziert. Die Sensoreinrichtung 70 umfasst einen Magnetfeldsensor 72 und erfasst einen Drehwinkel der Rotoreinheit 23 relativ zu der Statoreinheit 22. Durch die Verringerung lokaler magnetischer Streufelder kann die Genauigkeit der Winkelbestimmung erheblich verbessert werden.

Wird der magnetisch leitfähige äußere Bremskörper 3a der äußeren Bremskomponente 3 axial weiter in Richtung der Sensoreinrichtung 70 geführt, wirken die darin auftretenden und im Betrieb schnell und mehrfach wechselnden Magnetfelder sich auf die Genauigkeit negativ aus. Diese Konstruktion erhöht auf einfache Art und Weise die Genauigkeit ganz erheblich.

Eine weitere und deutliche Verbesserung der Messgenauigkeit wird über die Abschirmeinrichtung 75 und die Entkopplungseinrichtung 78 erzielt. Die Abschirmeinrichtung 75 erstreckt sich hier umlaufen und im Querschnitt etwa C- oder U-förmig um die Magnetringeinheit 71 herum, die hier an gegenüberliegenden radialen Stellen einen Südpol und einen Nordpol aufweist. Gemessen wird die Ausrichtung des Magnetfeldes an dem Statorschaft 22b. Je geringer dort die Einflüsse externer Magnetfelder oder des Magnetfeldes der Magnetfeldquelle 26 ist, desto genauer kann gemessen und somit auch die Bremseinrichtung 1 gesteuert werden.

Die Abschirmeinrichtung 75 weist in einem einfachen Fall mehrere Abschirmkörper 76 und Trenneinheiten 77 auf, die insgesamt die Abschirmeinrichtung 75 bilden. In einem konkreten Beispiel bilden zwei seitliche Scheibenringe und eine zylindrische Hülse drei aufeinander angepasste Abschirmkörper, die dicht aneinander anliegen und für eine zuverlässige Abschirmung nach außen sorgen. In Inneren des umlaufen Profils ist die Magnetringeinheit 71 aufgenommen und wird durch eine oder mehrere Trenneinheiten 77 beabstandet von den magnetisch leitfähigen Abschirmkörpern 76 gehalten. Dadurch werden äußeren Magnetfelder weitgehend von der Magnetringeinheit 71 und dem Magnetfeldsensor 72 abgehalten.

Zu der Verbesserung der Messgenauigkeit und der Einfachheit des Aufbaus trägt erheblich auch die Art und Anordnung der Dichtung 10 bei, die mit der Dichtungslippe 10b außen an dem Innenumfang des Rotorkörpers 23b bzw. dem äußeren Bremskörper 3a anliegt.

In der Figur 9 ist die Statoreinheit 22 zusammen mit dem Schafthalter 14 dargestellt. Die Rotoreinheit 23 ist hier zur besseren Übersicht nicht dargestellt. Der Kern 21 ist zu erkennen. Daneben ist eine Aufnahme bzw. Formelement 22c zur Führung der Übertragungskomponente bzw. Drehkörper 11 zu erkennen, die seitlich neben dem Kern ausgebildet sind.

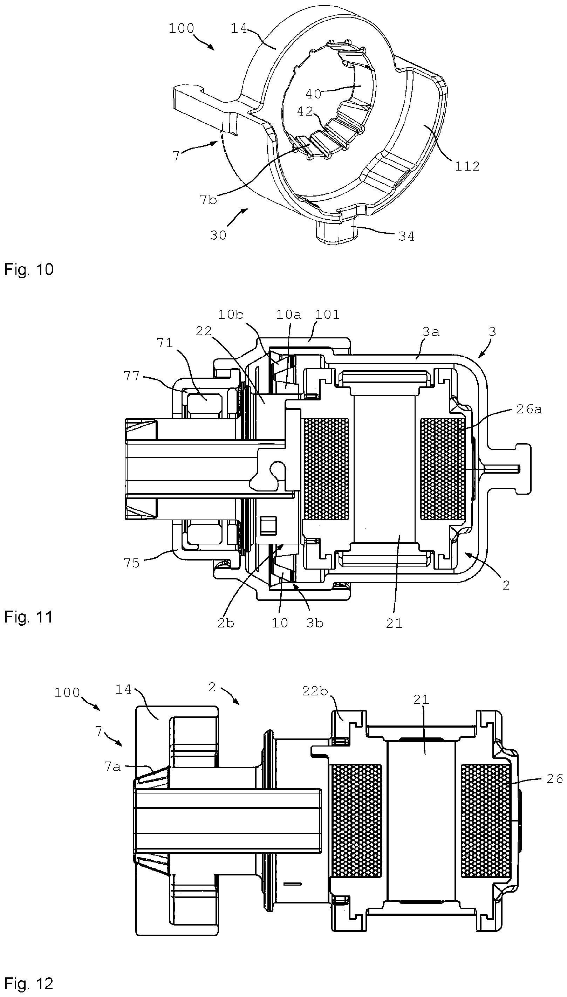

In der Figur 10 ist der Schafthalter 14 alleine dargestellt. So ist hier die Ausrichtungseinrichtung 7 mit dem Ausrichtungsabschnitt 7a des Statorschaftes 22b und dem Ausrichtungsteil 7b im Schafthalter 14 gut zu erkennen. Auch gut zu erkennen ist hier der radial innen liegende Aufnahmebereich des Schafthalters für die Lagerstelle 112. Dort können z. B. ein oder zwei oder mehr Lagerstellen der Lagereinheit 112 sein.

Der Schafthalter 14 ist hier mit einem Zapfen 34 ausgestattet, um eine drehfeste Anbindung an dem Tragkörper 50 zu ermöglichen (das Reaktionsmoment wird hierüber abgeleitet). Der Schafthalter 14 weist hier zudem im Aufnahmebereich für den Statorschaft 22b zwei Nuten 40 auf. Die Nuten 40 dienen zur drehfesten Aufnahme des Statorschaftes 22b. Dazu weist der Statorschaft 22b zwei entsprechende Erhebungen 41 auf, welche in die Nuten 40 eingreifen. Zudem weist der Schafthalter 14 hier Klebenuten 42 zur Aufnahme bzw. Verteilung eines Klebemittels auf. Mit dem Klebemittel wird der Statorschaft 22b an dem Schafthalter 14 verklebt.

Figur 11 zeigt einen Schnitt durch eine haptische Bedieneinrichtung 100, wobei die innere Bremskomponente 2 und die äußere Bremskomponente 3, die Dichtung 10, das Bedienteil 101 und auch die elektrische Spule 26a erkennbar sind. Auch der Schafthalter 14 ist zu sehen.

Figur 12 zeigt eine Ansicht der Statoreinheit 22 und des Schafthalters 14, wobei die Rotoreinheit 23 nicht zu sehen sind.

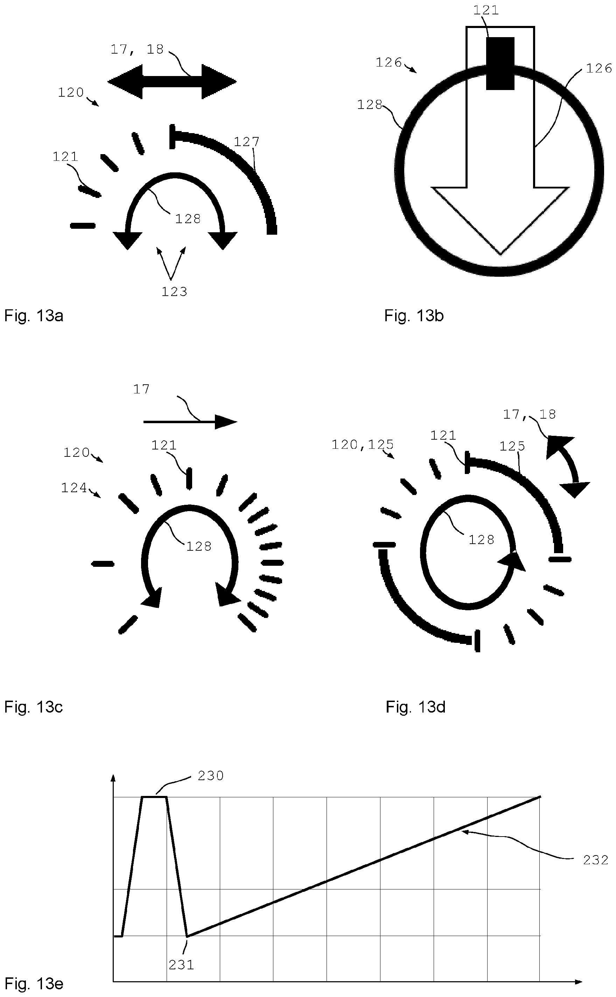

Figuren 13a bis 13d veranschaulichen verschiedene Haptikmodi bei der Bedienung der haptischen Bedieneinrichtung 100.

Figur 13a zeigt rein schematisch eine Darstellung einer Rasterung des Bewegungsbereichs beim Drehen des Bedienteils 101, wobei die Bewegbarkeit durch die magnetorheologische Bremseinrichtung beeinflusst wird und ein richtungsabhängiger Leerlauf zur Verfügung gestellt wird.

Die haptische Bedieneinrichtung 100 ist hier als Mausrad 106 ausgeführt oder umfasst ein solches. Ein Haptikmodus beschreibt hier eine mögliche Ausführungsform eines Verfahrens zur Steuerung des Bedienteils 101.

In dem hier dargestellten Haptikmodus arbeitet das Mausrad 106 richtungsabhängig in Abhängigkeit der Bewegung 809 in dem Bewegungsbereich 812. Wird das hier als Mausrad 106 ausgeführte Bedienteil 101 nach links gedreht, erzeugt die Bremseinrichtung 1 eine drehwinkelabhängige Rasterung 810 mit Anschlagpunkten 811, welche der Benutzer als überwindbaren Widerstand bei Drehen wahrnimmt. Wird das Mausrad 106 nach rechts bewegt, liegt ein Freilauf 829 vor, bei dem das Bedienteil 101 frei drehbar ist. Hierdurch wird dem Benutzer hier ermöglicht, ein direktes Feedback über seine Eingabe zu erhalten. Der Haptikmodus wird auch als Drücken und Blockieren 816 bezeichnet.

Ein weiterer Haptikmodus des Verfahrens ist in Figur 13b dargestellt. Nach einer Linearbewegung des Mausrads 103 wird die Bewegbarkeit des Bedienteils 101 durch die magnetorheologische Bremseinrichtung 1 vollständig gesperrt. Dadurch wird eine ungewollte parallele Fehleingabe des Benutzers effektiv vermieden. Die Kraft in dem Anschlagpunkt 121 ist so groß, dass ein Benutzer diese praktisch nicht überwinden kann.

In Figur 13c ist ein weiterer Haptikmodus dargestellt. Die Rasterung 120 im Bewegungsbereich 128 wird hier geschwindigkeitsabhängig 124 oder auch beschleunigungsabhängig 124 verändert. Bei einer schnellen Drehbewegung des Bedienteils 101 durch den Benutzer verändert sich dabei ein Abstand zwischen zwei nebeneinanderliegenden Rasterpunkten 121 geschwindigkeitsabhängig. Bei der dargestellten Bewegung 17 verringert sich mit steigender Geschwindigkeit der Abstand der Anschlagpunkte 121, welche der Benutzer beim Drehen wahrnimmt.

In Figur 13d ist eine weitere Ausführungsform des Verfahrens dargestellt. Das Bedienteil 101 ist hier frei durchdrehbar, sodass ein endloser Bewegungsbereich 128 vorliegt. In dem hier vorliegenden Fall werden einzelne Anschlagpunkte 121 der Rasterung 120 übersprungen (Rasterpunkte 125), wenn eine hohe Beschleunigung des Bedienteils 101 vorliegt. Es wird eine geschwindigkeitsabhängige Rasterung innerhalb des Bewegungsbereichs des Bedienteils durch die magnetorheologische Bremseinrichtung zur Verfügung gestellt.

Der Bewegungsbereich 128 eines Bedienteils 101 kann in Abhängigkeit des Haptikmodus veränderlich und insbesondere einstellbar sind. Vorteilhaft ist so eine Anpassung der Bewegbarkeit und einer haptischen Rückmeldung an die individuellen Bedürfnisses eines Benutzers bzw. in Abhängigkeit einer Benutzung bzw. eines Programms möglich.

Figur 13e zeigt die mögliche Verwendung beim Starten eines Programmes oder beim Bedien eines Gerätes wie z. B. eines Radios. Das Bedienteil 101 kann mit zunächst mit geringem Widerstand z. B. minimal - oder in anderen Fällen auch praktisch gar nicht - gedreht werden. Anschließend steigt das benötigte Drehmoment steil oder auch schlagartig bis zur Schwelle 230 an. Nach dem Überwinden der Schwelle 230 wird z. B. ein Gerät gestartet oder eingeschaltet. Der Drehwiderstand sinkt bis auf ein relatives minimales Moment 231 ab. Sofort danach wird hier die Funktion des Bedienteils 101 geändert. Beim Weiterdrehen wird z. B. die Lautstärke verändert. Hier wird linear das benötigte Drehmoment gemäß der Steigung 232 erhöht. Möglich ist es auch, dass der Verlauf nicht linear ist. Möglich ist es auch, dass ab einer gewissen Stellung (Lautstärke, Empfindlichkeit, Helligkeit einer Beleuchtung) eine stärkere Steigung eingestellt oder das benötigte Moment schlagartig ein gewisses Maß erhöht wird. So kann z. B. auch ein Fahrzeug über eine haptischen Bedieneinrichtung (z. B. mit einem Daumenrad/walze im Lenkrad) gestartet werden. Bei Drehung des Bedienteils 101 (z.B. eines Rades oder Drehknopfes) wird eine Schwelle erzeugt. Nach dem Überwinden der Schwelle wird eine Funktion gestartet, z. B. wie wenn der Zündschlüssel klassisch auf die erste Position gedreht wird. Der Drehwiderstand sinkt danach bis auf ein kleineres oder minimales Moment ab. Beim Weiterdrehen gelangt man in den eingeschalteten Modus oder zum Vorglühen bei Dieselmotoren. Der Widerstand erhöht sich dabei konstant. Weiteres Drehen startet den Motor, wie beim klassischen Zündschlüssel.

Diese Funktion kann auf beliebige Anwendungsfälle angepasst werden, z.B. auch beim Abnehmen eines Telefons. Zuerst nimmt der Benutzer das Gespräch entgegen, indem er den Drehknopf über eine Drehmomentschwelle gedreht werden muss. Danach nimmt das Drehmoment wieder einen geringeren Wert an und der Benutzer kann durch weiteres Drehen die Lautstärke erhöhen oder durch Gegendrehung reduzieren. Beim Auflegen des Telefongesprächs geschieht dasselbe in die umgekehrte Richtung. Selbes gilt für das Radio: zum Einschalten wird das Daumenrad über eine Schwelle gedreht, danach wird die Lautstärke erhöht, der Widerstand erhöht sich mit der Lautstärke.

Der vorzugsweise niederlegierte Stahl kann ein Restmagnetfeld behalten. Der Stahl wird vorzugsweise regelmäßig oder bei Bedarf entmagnetisiert (u.a. durch ein spezielles Wechselfeld).

Bevorzugt wird für die vom Magnetfeld durchflossenen Komponenten der Werkstoff FeSi3P (Siliziumstahl bzw. Silicon Steel) oder ein artverwandter Werkstoffe verwendet.

In allen Fällen kann eine Sprach- oder Geräuschsteuerung durchgeführt werden. Mit der Sprachsteuerung kann die Bremseinrichtung adaptiv gesteuert werden.

Die Steuerung kann zusätzlich durch künstliche Intelligenz (deep learning/ machine learning) unterstützt werden, um die haptischen Funktionen zusätzlich an die Benutzer anzupassen und zu verbessern.

Wenn die Dreheinheit nicht gedreht wird, d. h. der Winkel ist konstant, wird vorzugsweise über die Zeit der Strom kontinuierlich verringert. Der Strom kann auch geschwindigkeitsabhängig (Drehwinkelgeschwindigkeit der Dreheinheit) variiert werden.

**Bezugszeichenliste:**

| | | | |
|---|---|---|---|
| 1 | Magnetorheologische Bremseinrichtung | 22b | Statorschaft, Schaft |
| | | 22c | Formelement |
| 2 | Bremskomponente | 23 | Rotoreinheit, Drehknopf |
| 2b | Kontaktabschnitt | 23a | Hülse |
| 3 | Bremskomponente | 23b | Rotorkörper |
| 3a | Bremskörper | 23c | Höhe |
| 3b | Kontaktbereich | 23d | Wandstärke |
| 5 | Spalt, Kanal, Bremsspalt | 25 | radiale Richtung |
| 5a | Spaltbreite | 26 | Magnetfeldquelle |
| 6 | Medium | 26a | Spule |
| 7 | Ausrichtungseinrichtung | 26b | maximaler Durchmesser |
| 7a | Ausrichtungsabschnitt | 26c | Spulenebene |
| 7b | Ausrichtungsteil | 26d | radiale Richtung zu 26c |
| 8 | Feld, Magnetfeld | 27 | Steuereinrichtung |
| 9 | freier Abstand | 28 | Vergussmasse |
| 10 | Dichtung | 29 | Elektronikeinheit |
| 10a | Dichtungsbasis | 30 | Lagereinrichtung |
| 10b | Dichtungslippe | 32 | Quernut |
| 11 | Übertragungskomponente, Wälzkörper, Drehkörper | 34 | Zapfen |
| | | 35 | Kabeldurchführung |
| 12 | Drehachse | 37 | Fortsatz |
| 14 | Schafthalter | 39 | Volumenausgleich |
| 14a | Abschnitt | 40 | Nut |
| 14b | Abschnitt | 41 | Erhebung |
| 15 | Zylinder, Kugel | 42 | Klebenut |
| 16 | Keilform | 43 | Benutzerschnittstelle |
| 16a | spitzwinkliger Bereich | 44 | Wegbegrenzung |
| 17 | Richtung der Relativbewegung | 45 | Kabel |
| | | 49 | Überzug |
| 18 | Richtung der Relativbewegung | 50 | Tragkörper, Konsole |
| | | 61 | Winkelsegment |
| 19 | magnetische Partikel | 62 | Winkelsegment |
| 20 | axiale Richtung | 63 | Aufnahme für 11 |
| 21 | Kern | 64 | Außenoberfläche |
| 21b | minimaler Durchmesser | 65 | radiales Spaltmaß |
| 22 | Statoreinheit | 66 | radialer Abstand |
| 22a | Statorkörper | 67 | Innenoberfläche von 23b |
| 70 | Sensoreinrichtung | 110 | Bremskammer, geschlossene Kammer |
| 71 | Magnetringeinheit | | |
| 72 | Magnetfeldsensor | 112 | Lagereinheit erste Lagerstelle |
| 73 | Sensorleitung | | |
| 75 | Abschirmeinrichtung | 114 | Volumen von 110 |
| 76 | Abschirmkörper | 118 | Lagereinheit, zweite Lagerstelle |
| 77 | Trenneinheit | | |
| 78 | Entkopplungseinrichtung | 119 | Achsstummel |
| 100 | Haptische Bedieneinrichtung | 120 | Rasterung |
| | | 121 | Anschlagpunkt |
| 101 | Bedienkopf, Bedienteil | 122 | radiale Richtung (global) |
| 102 | Daumenwalze | 123 | Richtungsabhängigkeit |
| 103 | Computermaus | 124 | geschwindigkeitsabhängig, beschleunigungsabhängig |
| 103a | Mauskörper | | |
| 103b | Maustaste | 125 | Überspringen |
| 103c | Maustaste | 126 | Drücken und Blockieren |
| 104 | Joystick | 127 | Leerlauf, frei drehbar |
| 105 | Gamepad | 128 | Bewegungsbereich |
| 106 | Mausrad | 200 | Gerätekomponente |

## Patentansprüche

1. Haptische Bedieneinrichtung (100) mit einem drehbaren Bedienteil (101), wenigstens einer Magnetfeldquelle (26) und wenigstens einer magnetorheologischen Bremseinrichtung (1) zum Bremsen einer Drehbewegung des Bedienteils (101), wobei die magnetorheologische Bremseinrichtung (1) wenigstens zwei relativ zueinander drehbare Bremskomponenten (2, 3) umfasst, von denen eine mit dem drehbaren Bedienteil (101) gekoppelt ist, wobei die zweite Bremskomponente (3) als äußere Bremskomponente (3) die erste Bremskomponente (2) als innere Bremskomponente (2) wenigstens abschnittsweise umgibt,
und wobei zwischen den beiden Bremskomponenten (2, 3) eine mit einem magnetorheologischen Medium (6) versehene magnetorheologische Bremskammer (110) ausgebildet ist, welche wenigstens einen Spalt (5) aufweist, wobei sich die innere Bremskomponente (2) in einer axialen Richtung (20) erstreckt und wobei die innere Bremskomponente (2) als Statoreinheit (22) und die äußere Bremskomponente (3) als Rotoreinheit (23) ausgebildet sind und wobei die äußere Bremskomponente (3) über wenigstens eine Lagereinheit (112, 118) an einem Tragkörper (50) drehbar gelagert ist,
**dadurch gekennzeichnet,**
**dass** die wenigstens eine Lagereinheit (112, 118) wenigstens ein Festlager zum Blockieren einer axialen Bewegbarkeit der äußeren Bremskomponente (3) bereitstellt und mit der Lagereinheit (112, 118) eine von der inneren Bremskomponente (2) unabhängige Lagerung der äußere Bremskomponente (3) erfolgt.

2. Haptische Bedieneinrichtung (100) nach Anspruch 1, wobei die äußere Bremskomponente (3) einen äußeren Bremskörper (3a) umfasst, der wenigstens abschnittsweise eine zylindrische Innenoberfläche (67) aufweist und wobei an wenigstens einem Winkelsegment (61, 62) des Außenumfangs des Kerns (21) wenigstens eine Übertragungskomponente (11) zwischen dem Kern (21) und der zylindrischen Innenoberfläche des äußeren Bremskörpers (3a) angeordnet ist,
und wobei an dem Winkelsegment (61, 62) der Kern (21) und/oder seitlich neben dem Kern (21) an der Statoreinheit (22) ausgebildete Formelemente (22c) wenigstens eine an die Form der Übertragungskomponenten (11) angepasste Aufnahme (63) aufweist und wobei die Außenoberfläche (64) des Kerns (21) über dem Winkelsegment (61, 62) zylindrisch ausgebildet ist.

3. Haptische Bedieneinrichtung (100) nach einem der vorhergehenden Ansprüche, wobei die magnetorheologische Bremskammer (110) über wenigstens eine Dichtung (10) abgedichtet ist und wobei die Dichtung (10) eine mit der inneren Bremskomponente (2) verbundene Dichtungsbasis (10a) und eine an der äußeren Bremskomponente (3) anliegende Dichtungslippe (3b) umfasst
und wobei der Spalt (5) mit einem Magnetfeld (8) der Magnetfeldquelle (26) beaufschlagbar ist und wobei das Magnetfeld den Spalt (5) durchtritt und durch einen magnetisch leitfähigen äußeren Bremskörper (3a) der äußeren Bremskomponente (3) geleitet wird,
und wobei die äußere Bremskomponente (3) in einem Kontaktbereich (3b) mit der Dichtungslippe (10b) widerstandsfähiger gegen Abrasion als die innere Bremskomponente (2) in einem Kontaktabschnitt (2b) mit der Dichtungsbasis (10a) ausgebildet ist.

4. Haptische Bedieneinrichtung (100) nach einem der vorhergehenden Ansprüche, umfassend wenigstens eine Benutzerschnittstelle (43), ein Bedienpanel, ein Display, ein berührungsempfindliches Display mit oder ohne haptischem Feedback und wobei an der äußeren Bremskomponente (3) das Bedienteil (101) ausgebildet ist und z. B. als Drehteil (13), Drehknopf (23), Mausrad (106) oder Drehrad ausgebildet ist.

5. Haptische Bedieneinrichtung (100) nach einem der vorhergehenden Ansprüche, wobei das Bedienteil (101) den äußeren Bremskörper (3a) aus einem magnetisch leitenden Material umfasst und einen Außenring (14a) für das Magnetfeld zur Verfügung stellt und wobei wenigstens eine radiale Wandstärke (23d) des äußeren Bremskörper (3a) wenigstens halb so groß ist wie eine Spaltbreite (5a) des Spaltes (5) und/oder ein Durchmesser (11a) einer Übertragungskomponente (11) .

6. Haptische Bedieneinrichtung (1) nach einem der vorhergehenden Ansprüche, wobei die äußere Bremskomponente (3) mittels der Lagereinheit (112) nach radial außen an dem Tragkörper (50) gelagert ist und wobei die Lagereinheit (112) an einer radialen Außenseite der äußeren Bremskomponente (3) angeordnet ist und wobei die äußere Bremskomponente (3) wenigstens teilweise zwischen der Lagereinheit (112) und der inneren Bremskomponente (2) angeordnet ist.

7. Haptische Bedieneinrichtung (1) nach einem der vorhergehenden Ansprüche, wobei die Lagereinheit (112) die äußere Bremskomponente (3) nur teilweise radial umgibt und wobei die Lagereinheit (112) die äußere Bremskomponente (3) formschlüssig radial umgibt, sodass die äußere Bremskomponente (3) die Lagereinheit (112) in radialer Richtung nicht verlassen kann und wobei die äußere Bremskomponente (3) nur mit einem radialen Teilabschnitt ihres Umfangs an dem Tragkörper (50) gelagert ist.

8. Haptische Bedieneinrichtung (1) nach einem der vorhergehenden Ansprüche, wobei die äußere Bremskomponente (3) nicht an der inneren Bremskomponente (2) und vorzugsweise nur an dem Tragkörper (50) gelagert ist,
und/oder wobei der wenigstens einen Lagereinheit (112) wenigstens eine Wegbegrenzung (44) für eine axiale Bewegbarkeit der äußeren Bremskomponente (3) in wenigstens eine Richtung zugeordnet ist.

9. Haptische Bedieneinrichtung (1) nach einem der vorhergehenden Ansprüche, wobei ein Schaft (22b) der inneren Bremskomponente (2) mittels wenigstens eines Schafthalters (14) an dem Tragkörper (50) angeordnet ist,
und wobei die Statoreinheit (22) drehfest an dem Schafthalter (14) angeordnet ist und wobei der Schafthalter (14) axial verschiebbar an dem Tragkörper (50) angeordnet ist und wobei der Schafthalter (14) die äußere Bremskomponente (3) wenigstens abschnittsweise radial umgibt.

10. Haptische Bedieneinrichtung (1) nach einem der vorhergehenden Ansprüche, wobei die innere Bremskomponente (2) nur einseitig an dem Tragkörper (50) befestigt ist und insbesondere nur mit einem Endabschnitt eines Schafts (22b) an dem Tragkörper (50) befestigt ist.

11. Haptische Bedieneinrichtung (1) nach einem der vorhergehenden Ansprüche, umfassend wenigstens eine Ausrichtungseinrichtung (7) zum Ausrichten einer axialen Mittelachse der inneren Bremskomponente (2), insbesondere eines Schafts (22b), relativ zu einer axialen Mittelachse bzw. Drehachse der äußeren Bremskomponente (3),
wobei mittels der Ausrichtungseinrichtung (7) wenigstens der Schaft (22b) der inneren Bremskomponente (2) an dem Schafthalter (14) ausrichtbar ist,
wobei der Schaft (22b) dazu wenigstens einen konischen Ausrichtungsabschnitt (7a) umfasst, welcher in und/oder an einem korrespondieren konischen Ausrichtungsteil (7b) des Schafthalters (14) angeordnet ist,
und wobei mittels der Ausrichtungseinrichtung (7) der Schafthalter (14) an dem Tragkörper (50) und/oder die äußere Bremskomponente (3) an dem Schafthalter (14) ausrichtbar ist.

12. Haptische Bedieneinrichtung (1) nach dem vorhergehenden Anspruch, wobei der Schafthalter (14) dazu wenigstens teilweise achsensymmetrisch ausgebildet ist, sodass eine axiale Mittelachse eines Abschnitts (14a) des Schafthalters (14), welcher die äußere Bremskomponente (3) radial umgibt,
und eine axiale Mittelachse eines Abschnitts (14b) des Schafthalters (14), an welchem die innere Bremskomponente (2) befestigt ist, parallel und insbesondere überdeckend angeordnet sind
und/oder wobei die äußere Bremskomponente (3) an einem Abschnitt (14a) des Schafthalters (14), welcher die äußere Bremskomponente (3) radial umgibt, drehbar gelagert ist.

13. Haptische Bedieneinrichtung (1) nach einem der vorhergehenden Ansprüche, wobei ein Abschnitt (14a) des Schafthalters (14), welcher die äußere Bremskomponente (3) radial umgibt, mit seiner Außenseite wenigstens teilweise in dem Tragkörper (50) angeordnet und vorzugsweise drehfest angeordnet ist,
und/oder wobei ein bei einer Verzögerung der Drehbewegung der äußeren Bremskomponente (3) auftretendes Verzögerungsmoment über die innere Bremskomponente (2) in den Tragkörper (50) ableitbar ist
und/oder wobei eine im Rahmen eines Bedienvorgangs auf die äußere Bremskomponente (3) ausgeübte Druckbelastung wenigstens über die Lagereinheit (112) unter Umgehung der inneren Bremskomponente (2) in den Tragkörper (50) ableitbar ist.

## Claims

1. A haptic operating device (100) with a rotatable operating member (101), at least one magnetic field source (26) and at least one magnetorheological braking device (1) for braking a rotary motion of the operating member (101),
wherein the magnetorheological braking device (1) comprises at least two brake components (2, 3) rotatable relative to one another, one of which is coupled with the rotatable operating member (101), wherein the second brake component (3) as the outer brake component (3) surrounds the first brake component (2) as the inner brake component (2) at least in sections,
and wherein between the two brake components (2, 3) a magnetorheological braking chamber (110) provided with a magnetorheological medium (6) is configured, which comprises at least one gap (5), wherein the inner brake component (2) extends in the axial direction (20),
and wherein the inner brake component (2) is configured as a stator unit (22) and the outer brake component (3), as a rotor unit (23), and wherein the outer brake component (3) is rotatably supported on a supporting body (50) by way of at least one bearing unit (112, 118),
**characterized in**
**that** the at least one bearing unit (112, 118) provides at least one fixed bearing for blocking the axial movability of the outer brake component (3), and that the bearing unit (112, 118) acts as a support of the outer brake component (3) independently of the inner brake component (2).

2. The haptic operating device (100) according to claim 1, wherein the outer brake component (3) comprises an outer brake body (3a), which comprises a cylindrical inner surface (67) at least in sections, and wherein at least one transmission component (11) is disposed on at least one angle segment (61, 62) of the outer periphery of the core (21) between the core (21) and the cylindrical inner surface of the outer brake body (3a),
and wherein the core (21) configured on the angle segment (61, 62) and/or mold elements (22c) configured laterally adjacent to the core (21) on the stator unit (22), comprise at least one takeup (63) adapted to the shape of the transmission components (11), and wherein the outer surface (64) of the core (21) is configured cylindrically over the angle segment (61, 62).

3. The haptic operating device (100) according to any of the preceding claims, wherein the magnetorheological braking chamber is sealed (110) by at least one seal (10), and wherein the seal (10) comprises a sealing base (10a) connected with the inner brake component (2) and a sealing lip (3b) contacting the outer brake component (3),
and wherein the gap (5) can be exposed to a magnetic field (8) of the magnetic field source (26), and wherein the magnetic field passes through the gap (5) and is guided through a magnetically conductive, outer brake body (3a) of the outer brake component (3),
and wherein the outer brake component (3) is configured more abrasion-resistant in a contact area (3b) with the sealing lip (10b) than is the inner brake component (2) in a contact portion (2b) with the sealing base (10a).

4. The haptic operating device (100) according to any of the preceding claims, comprising at least one user interface (43), one operating panel, one display, one touch-sensitive display with or without haptic feedback, and wherein the operating member (101) is configured on the outer brake component (3) and is e.g. configured as a rotary part (13), rotary knob (23), mouse wheel (106) or rotary dial.

5. The haptic operating device (100) according to any of the preceding claims, wherein the operating member (101) comprises the outer brake body (3a) of a magnetically conducting material and provides an outer ring (14a) for the magnetic field, and wherein at least one radial wall thickness (23d) of the outer brake body (3a) is at least half the size of the gap width (5a) of the gap (5) and/or the diameter (11a) of the transmission component (11).

6. The haptic operating device (100) according to any of the preceding claims, wherein the outer brake component (3) is supported radially outwardly on the supporting body (50) by means of the bearing unit (112), and wherein the bearing unit (112) is disposed on the radially outwardly face of the outer brake component (3), and wherein the outer brake component (3) is at least partially disposed between the bearing unit (112) and the inner brake component (2).

7. The haptic operating device (100) according to any of the preceding claims, wherein the bearing unit (112) radially surrounds the outer brake component (3) partially only, and wherein the bearing unit (112) radially surrounds the outer brake component (3) in a form-fit, so that the outer brake component (3) cannot detach from the bearing unit (112) in the radial direction, and wherein the outer brake component (3) is supported on the supporting body (50) only with a radial part section of the circumference.

8. The haptic operating device (100) according to any of the preceding claims, wherein the outer brake component (3) is not supported on the inner brake component (2) and preferably only on the supporting body (50),
and/or wherein the at least one bearing unit (112) is provided with at least one travel limit (44) for the axial movability of the outer brake component (3) in at least one direction.

9. The haptic operating device (100) according to any of the preceding claims, wherein the shaft (22b) of the inner brake component (2) is disposed on the supporting body (50) by means of at least one shaft holder (14),
and wherein the stator unit (22) is non-rotatably disposed on the shaft holder (14), and wherein the shaft holder (14) is axially displaceably disposed on the supporting body (50), and wherein the shaft holder (14) radially surrounds the outer brake component (3) at least in sections.

10. The haptic operating device (100) according to any of the preceding claims, wherein the inner brake component (2) is fastened to the supporting body (50) on one side only, and is in particular fastened to the supporting body (50) only at an end portion of the shaft (22b).

11. The haptic operating device (100) according to any of the preceding claims, comprising at least one alignment device (7) for aligning the axial center axis of the inner brake component (2), in particular of a shaft (22b), relative to the axial center axis respectively rotation axis of the outer brake component (3),
wherein at least the shaft (22b) of the inner brake component (2) can be aligned by the shaft holder (14) by means of the alignment device (7),
wherein to this end, the shaft (22b) comprises at least one conical alignment section (7a) , which is disposed in and/or on a corresponding conical alignment portion (7b) of the shaft holder (14),
and wherein the shaft holder (14) can be aligned to the supporting body (50) and/or the outer brake component (3), to the shaft holder (14), by means of the alignment device (7).

12. The haptic operating device (1) according to the preceding claim, wherein the shaft holder (14) is at least partially configured axially symmetrical, so that the axial center axis of a section (14a) of the shaft holder (14), which radially surrounds the outer brake component (3), and the axial center axis of a section (14b) of the shaft holder (14), to which the inner brake component (2) is fastened, are disposed in parallel and in particular overlapping,
and/or wherein the outer brake component (3) is rotatably supported on a section (14a) of the shaft holder (14), which radially surrounds the outer brake component (3).

13. The haptic operating device (100) according to any of the preceding claims, wherein a section (14a) of the shaft holder (14), which radially surrounds the outer brake component (3), is disposed, and preferably disposed non-rotatably with its outside surface at least partially in the supporting body (50),
and/or wherein a deceleration torque building up in the case of the rotary motion of the outer brake component (3) decelerating, can be discharged by way of the inner brake component (2) into the supporting body (50),
and/or wherein in the scope of operation, a compressive load applied on the outer brake component (3) can be discharged at least via the bearing unit (112), bypassing the inner brake component (2) in the supporting body (50).

## Revendications

1. Dispositif de commande haptique (100) doté d'un élément de commande rotatif (101), d'au moins une source de champ magnétique (26) et d'au moins un dispositif de freinage magnéto-rhéologique (1) pour freiner un mouvement de rotation de l'élément de commande (101), le dispositif de freinage magnéto-rhéologique (1) comprenant au moins deux composants de freinage (2, 3) pouvant être mis en rotation l'un par rapport à l'autre, dont l'un est couplé à l'élément de commande rotatif (101), le deuxième composant de freinage (3), en tant que composant de freinage extérieur (3) entourant au moins par sections le premier composant de freinage (2) en tant que composant de freinage intérieur (2),
et une chambre de freinage magnéto-rhéologique (110) pourvue d'un milieu magnéto-rhéologique (6) étant réalisée entre les deux composants de freinage (2, 3), laquelle chambre présente au moins une fente (5), le composant de freinage intérieur (2) s'étendant dans un sens axial (20) et le composant de freinage intérieur (2) étant réalisé sous la forme d'une unité de stator (22) et le composant de freinage extérieur (3), lui, sous la forme d'une unité de rotor (23), et le composant de freinage extérieur (3) étant monté rotatif sur un corps de support (50) par l'intermédiaire d'au moins une unité de palier (112, 118),
**caractérisé en ce que**
ladite au moins une unité de palier (112, 118) fournit au moins un palier fixe pour bloquer une mobilité axiale du composant de freinage extérieur (3), et **en ce qu'**avec l'unité de palier (112, 118), un palier de composant de freinage extérieur (3) indépendant du composant de freinage intérieur (2) est réalisé.

2. Dispositif de commande haptique (100) selon la revendication 1, le composant de freinage extérieur (3) comprenant un corps de freinage extérieur (3a) qui présente au moins par sections une surface intérieure cylindrique (67), et au moins un composant de transmission (11) étant, sur au moins un segment angulaire (61, 62) de la périphérie extérieure du noyau (21), disposé entre ledit noyau (21) et la surface intérieure cylindrique du corps de freinage extérieur (3a),
et, sur le segment angulaire (61, 62), le noyau (21) et/ou des éléments de moulage (22c) formés latéralement à côté du noyau (21) sur l'unité de stator (22) présentant au moins un logement (63) adapté à la forme des composants de transmission (11) et la surface extérieure (64) du noyau (21) étant réalisée de manière cylindrique au-dessus du segment angulaire (61, 62).

3. Dispositif de commande haptique (100) selon l'une quelconque des revendications précédentes, la chambre de freinage magnéto-rhéologique (110) étant rendue étanche par au moins un joint d'étanchéité (10), et le joint d'étanchéité (10) comprenant une base d'étanchéité (10a) reliée au composant de freinage intérieur (2) et une lèvre d'étanchéité (3b) s'appliquant contre le composant de freinage extérieur (3)
et la fente (5) pouvant être soumise à un champ magnétique (8) de la source de champ magnétique (26), et le champ magnétique traversant la fente (5) et étant guidé à travers un corps de freinage extérieur magnétiquement conducteur (3a) du composant de freinage extérieur (3),
et le composant de freinage extérieur (3) étant réalisé de manière à être plus résistant à l'abrasion dans une zone de contact (3b) avec la lèvre d'étanchéité (10b) que le composant de freinage intérieur (2) dans une partie de contact (2b) avec la base d'étanchéité (10a).

4. Dispositif de commande haptique (100) selon l'une quelconque des revendications précédentes, comprenant au moins une interface utilisateur (43), un panneau de commande, un écran, un écran tactile avec ou sans retour haptique, et l'élément de commande (101) étant réalisé sur le composant de freinage extérieur (3) et étant réalisé par exemple sous la forme d'un élément rotatif (13), d'un bouton rotatif (23), d'une molette de souris (106) ou d'une roue rotative.

5. Dispositif de commande haptique (100) selon l'une quelconque des revendications précédentes, l'élément de commande (101) comprenant le corps de freinage extérieur (3a) en un matériau magnétiquement conducteur et fournissant une bague extérieure (14a) pour le champ magnétique et au moins une épaisseur de paroi radiale (23d) du corps de frein extérieur (3a) étant au moins deux fois plus petite qu'une largeur de fente (5a) de la fente (5) et/ou qu'un diamètre (11a) d'un composant de transmission (11).

6. Dispositif de commande haptique (1) selon l'une quelconque des revendications précédentes, le composant de freinage extérieur (3) étant disposé sur le corps de support (50) au moyen de l'unité de palier (112) vers l'extérieur dans le sens radial, et ladite unité de palier (112) étant disposée sur un côté extérieur radial du composant de freinage extérieur (3), et le composant de freinage extérieur (3) étant disposé au moins partiellement entre l'unité de palier (112) et le composant de freinage intérieur (2).

7. Dispositif de commande haptique (1) selon l'une quelconque des revendications précédentes, l'unité de palier (112) n'entourant que partiellement radialement le composant de freinage extérieur (3), et ladite unité de palier (112) entourant radialement le composant de freinage extérieur (3) par complémentarité de forme, de sorte que le composant de freinage extérieur (3) ne peut pas quitter ladite unité de palier (112) dans le sens radial, et le composant de freinage extérieur (3) n'étant disposé sur le corps de support (50) que par une section partielle radiale de sa périphérie.

8. Dispositif de commande haptique (1) selon la revendication précédente, le composant de freinage extérieur (3) n'étant pas disposé sur le composant de freinage intérieur (2) et de préférence seulement sur le corps de support (50),
et/ou une limitation de course (44) étant associée à ladite au moins une unité de palier (112) pour une mobilité axiale du composant de freinage extérieur (3) dans au moins un sens.

9. Dispositif de commande haptique (1) selon l'une quelconque des revendications précédentes, une tige (22b) du composant de freinage intérieur (2) étant agencée sur ledit corps de support (50) au moyen d'au moins un support de tige (14),
et l'unité de stator (22) étant agencée de manière solidaire en rotation sur le support de tige (14) et le support de tige (14) étant agencé de manière à pouvoir se déplacer axialement sur le corps de support (50), et le support de tige (14) entourant radialement le composant de freinage extérieur (3) au moins par sections.

10. Dispositif de commande haptique (1) selon l'une quelconque des revendications précédentes, le composant de freinage intérieur (2) n'étant fixé que d'un côté au corps de support (50) et notamment n'est fixé au corps de support (50) que par une partie d'extrémité d'une tige (22b).

11. Dispositif de commande haptique (1) selon l'une quelconque des revendications précédentes, comprenant au moins un dispositif d'alignement (7) pour mettre en position un axe médian axial du composant de freinage intérieur (2), notamment d'une tige (22b), par rapport à un axe médian radial ou axe de rotation du composant de freinage extérieur (3),
au moins la tige (22b) du composant de freinage intérieur (2) pouvant être mise en position par rapport au support de tige (14) au moyen du dispositif d'alignement(7),
la tige (22b) comprenant à cet effet au moins une section d'orientation conique (7a) qui est agencée dans et/ou sur une partie d'alignement conique (7b) correspondante du support de tige (14),
et, au moyen du dispositif d'alignement (7), le support de tige (14) pouvant être mis en position sur le corps de support (50) et/ou le composant de freinage extérieur (3) sur le support de tige (14).

12. Dispositif de commande haptique (1) selon la revendication précédente, le support de tige (14) étant réalisé à cet effet au moins partiellement avec une symétrie axiale, de sorte qu'un axe médian axial d'une section (14a) du support de tige (14), qui entoure radialement le composant de freinage extérieur (3), et un axe médian axial d'une section (14b) du support de tige (14), sur laquelle est fixé le composant de freinage intérieur (2), sont agencés parallèlement et notamment en se chevauchant, et/ou le composant de freinage extérieur (3) étant disposé rotatif sur une section (14a) du porteur de tige (14) qui entoure radialement le composant de freinage extérieur (3).

13. Dispositif de commande haptique (1) selon l'une quelconque des revendications précédentes, une section (14a) du support de tige (14), qui entoure le composant de freinage extérieur (3), étant agencée avec sa face extérieure au moins partiellement dans le corps de support (50) et de préférence fixe en rotation, et/ou un couple de décélération apparaissant lors d'un ralentissement du mouvement de rotation du composant de freinage extérieur (3) pouvant être dérivé dans le corps de support (50) par l'intermédiaire du composant de freinage intérieur (2)
et/ou une charge de pression exercée sur le composant de freinage extérieur (3) dans le cadre d'une opération de commande pouvant être dérivée dans le corps de support (50) au moins par l'intermédiaire de l'unité de palier (112) en contournant le composant de freinage intérieur (2).
